# EUROPEAN PATENT APPLICATION

(11) **EP 4 794 207 A1**
(43) Date of publication of application: **19.08.2026**
(21) Application number: 24884656.0
(22) Date of filing: 28.10.2024
(51) Int. Cl.: H03M 13/13

(54) **CODING METHOD AND APPARATUS FOR POLAR CODE**

(30) Priority: 31.10.2023 CN 202311444208
(71) Applicant: HUAWEI TECHNOLOGIES CO., LTD., Shenzhen 518129 (CN)
(72) Inventor: QIN, Kangjian, Shenzhen, Guangdong 518129 (CN); ZHANG, Huazi, Shenzhen, Guangdong 518129 (CN); TONG, Jiajie, Shenzhen, Guangdong 518129 (CN); WANG, Xianbin, Shenzhen, Guangdong 518129 (CN); LIU, Ke, Shenzhen, Guangdong 518129 (CN); WANG, Jun, Shenzhen, Guangdong 518129 (CN)
(74) Representative: MERH-IP Matias Erny Reichl Hoffmann Patentanwälte PartG mbB
(86) International application number: PCT/CN2024/127744
(87) International publication number: WO 2025/092653

(57) **Abstract**

A polar code encoding method and an apparatus relating to the field of communication technologies are provided, to reuse a sub-block interleaving rate matching approach of NR PC-polar codes for nested PC-polar codes, so as to improve NR compatibility. The method includes: mapping, based on a reliability sequence with a length of N, an information bit sequence with a length of k to k bit positions in a first sequence with a length of N, to obtain a second sequence, where the second sequence includes k information bits, x parity check PC bits, and (N-k-x) frozen bits, and k, N, and x are all positive integers; m information bits in the k information bits are at first m bit positions in the second sequence sorted in descending order of reliability, and remaining (k-m) information bits in the k information bits are at bit positions that are in the second sequence and that correspond to first (k-m) information bits in a preset information bit set sorted in descending order of reliability; and the x PC bits are x PC bits in a preset PC bit set; and performing polar encoding on the second sequence to obtain a third sequence.

## Description

This application claims priority to Chinese Patent Application No. 202311444208.8, filed with the China National Intellectual Property Administration on October 31, 2023 and entitled "POLAR CODE ENCODING METHOD AND APPARATUS", which is incorporated herein by reference in its entirety.

### TECHNICAL FIELD

Embodiments of this application relate to the field of communication technologies, and in particular, to a polar code encoding method and an apparatus.

### BACKGROUND

In communication systems, to reduce coding complexity, a coding scheme based on parity-check polar codes (parity-check polar codes, PC-polar codes) is proposed. The PC-polar codes may include new radio (new radio, NR) PC-polar codes and nested PC-polar codes.

In NR PC-polar codes, rate matching may be first performed, and then based on a code length after the rate matching and a code rate, information bits, frozen bits, and PC bits are determined. In contrast to the NR PC-polar codes, in nested PC-polar codes, information bits, frozen bits, and PC bits are independent of the code length after the rate matching and the code rate. PC bits and PC equations corresponding to sequences of different quantities of information bits are nested. For the nested PC-polar codes, the information bits, the frozen bits, and the PC bits may be first determined, followed by rate matching.

However, the rate matching scheme of the nested PC-polar codes is based on performance-oriented, nested puncturing sequence approaches, and therefore cannot reuse the sub-block interleaving rate matching approach of the NR PC-polar codes, leading to poor NR compatibility.

### SUMMARY

This application provides a polar code encoding method and an apparatus, to reuse a sub-block interleaving rate matching approach of NR PC-polar codes for nested PC-polar codes, so as to improve NR compatibility.

According to a first aspect, an embodiment of this application provides a polar code encoding method. The method may be performed by a transmitter device. Unless otherwise specified, the "transmitter device" in this application may be a transmitter device, or a component (for example, a processor, a chip, or a chip system) in the transmitter device, or may be a logical module or software that can implement some or all functions of the transmitter device. The method includes: mapping, based on a reliability sequence with a length of N, an information bit sequence with a length of k to k bit positions in a first sequence with a length of N, to obtain a second sequence, where the second sequence includes k information bits, x parity check PC bits, and (N-k-x) frozen bits, and k, N, and x are all positive integers; m information bits in the k information bits are at first m bit positions in the second sequence sorted in descending order of reliability, and remaining (k-m) information bits in the k information bits are at bit positions that are in the second sequence and that correspond to first (k-m) information bits in a preset information bit set sorted in descending order of reliability; and the x PC bits are x PC bits in a preset PC bit set; and performing polar encoding on the second sequence to obtain a third sequence.

According to the first aspect, a polar code encoding scheme with a nesting property is provided. For sequences of different quantities of information bits, a polar code may be constructed based on the same m information bits, the preset information bit set, and the preset PC bit set. The m information bits, the preset information bit set, and the preset PC bit set have a nesting property for the sequences of different quantities of information bits, and do not change with the quantity of information bits in the sequence. In addition, a sub-block interleaving rate matching manner of an NR PC-polar code may be reused for the PC-polar code having the nesting property obtained based on the m information bits, the preset information bit set, and the preset PC bit set. The PC-polar code having the nesting property still has good rate matching performance in the sub-block interleaving rate matching manner of the NR PC-polar code. This can simplify a rate matching operation, improve NR compatibility, and improve communication performance.

In a possible design, a value of k is any one of 7, 8, 9, 10, or 11.

In a possible design, the m information bits are at the following bit positions in the second sequence: 15, 23, 27, 29, 30, and 31.

Based on this possible design, the transmitter device may determine the m information bits in the second sequence based on a specific value of m and the reliability sequence. For example, the transmitter device may determine the first m bit positions in the second sequence sorted in descending order of reliability as the m information bits. The m information bits have a nesting property for sequences of different quantities (for example, k is equal to 7, 8, 9, 10, or 11) of information bits, and do not change with a length of the information bit sequence. This reduces decoding complexity, and improves decoding performance.

In a possible design, the preset information bit set corresponds to the following bit positions in the second sequence: 11, 19, 13, 14, and 22.

Based on this possible design, the preset information bit set has a nesting property for sequences of different quantities (for example, k is equal to 7, 8, 9, 10, or 11) of information bits, and does not change with a length of the information bit sequence. This can reduce decoding complexity and improve decoding performance.

In a possible design, a difference between indexes of any two bit positions checked by the PC bit is not 1.

Based on this possible design, by setting the difference between indexes of any two bit positions checked by any one PC bit in the preset PC bit set not to be 1, decoding performance and rate matching performance can be improved.

In a possible design, the preset PC bit set corresponds to the following bit positions in the second sequence: 21, 26, 25, and 28.

Based on this possible design, the preset PC bit set has a nesting property for sequences of different quantities (for example, k is equal to 7, 8, 9, 10, or 11) of information bits, and does not change with a length of the information bit sequence. This can reduce decoding complexity and improve decoding performance.

In a possible design, when the PC bit is at the 21^{st} bit position in the second sequence, a bit position checked by the PC bit is one or more of the following bit positions in the second sequence: 11 and 14; or when the PC bit is at the 26^{th} bit position in the second sequence, a bit position checked by the PC bit is one or more of the following bit positions in the second sequence: 13 and 19; or when the PC bit is at the 25^{th} bit position in the second sequence, a bit position checked by the PC bit is one or more of the following bit positions in the second sequence: 13 and 22; or when the PC bit is at the 28^{th} bit position in the second sequence, a bit position checked by the PC bit is one or more of the following bit positions in the second sequence: 11, 13, and 19.

Based on this possible design, a preferred example is provided for the PC bit and the bit position checked by the PC bit, so that decoding performance and rate matching performance can be improved.

In a possible design, a bit position 7 in the second sequence is a frozen bit.

Based on this possible design, if a sub-block interleaving-based rate matching manner featuring front-to-back puncturing is used, as the bit position 7 is relatively near to a start of the sequence, when E=24, 23, 22, 21, 20, 19, or 18, the bit position 7 is punctured. Therefore, the bit position 7 is pre-frozen. The bit position 7 in the second sequence may be set as a frozen bit (or may be referred to as a pre-frozen bit).

According to a second aspect, an embodiment of this application provides a polar code encoding method. The method may be performed by a transmitter device. Unless otherwise specified, the "transmitter device" in this application may be a transmitter device, or a component (for example, a processor, a chip, or a chip system) in the transmitter device, or may be a logical module or software that can implement some or all functions of the transmitter device. The method includes: mapping, based on a reliability sequence with a length of N, an information bit sequence with a length of k to k bit positions in a first sequence with a length of N, to obtain a fourth sequence, where the fourth sequence includes k information bits, 0 parity check PC bits, and (N-k) frozen bits, and both k and N are positive integers; performing polar encoding on the fourth sequence to obtain a fifth sequence; and performing rate matching on the fifth sequence in a front-to-back puncturing manner, to obtain a sixth sequence.

According to a second aspect, a polar code encoding scheme with a nesting property is provided. For sequences of different quantities k of information bits, k information bits and 0 PC bits may be determined based on the same reliability sequence to construct a polar code. The k information bits and the 0 PC bits have a nesting property for the sequences of different quantities of information bits, and do not change with the quantity of information bits in the sequence. In addition, the PC-polar code having the nesting property obtained based on the k information bits and the 0 PC bits may use a sub-block interleaving rate matching manner, of an NR PC-polar code, featuring front-to-back puncturing, to ensure a nesting property of the information bit. The PC-polar code having the nesting property still has good rate matching performance in the sub-block interleaving rate matching puncturing scheme of the NR PC-polar code. This can simplify a rate matching operation, improve NR compatibility, and improve communication performance.

In a possible design, a value of k is any one of 3, 4, 5, or 6.

In a possible design, before performing rate matching on the fifth sequence in the front-to-back puncturing manner, the method further includes: perform sub-block interleaving on the fifth sequence based on a first interleaving pattern, where the first interleaving pattern is used indicate that a value in an A^{th} sub-block of the fifth sequence is to be permuted and placed onto a B^{th} sub-block of the interleaved fifth sequence, and a mapping relationship between A and B is: (31, 31), (30, 30), (29, 29), (27, 28), (28, 27), (26, 26), (25, 25), (24, 24), (23, 23), (15, 22), (22, 21), (14, 20), (21, 19), (13, 18), (20, 17), (12, 16), (19, 15), (11, 14), (18, 13), (10, 12), (17, 11), (9, 10), (16, 9), (8, 8), (7, 7), (6, 6), (5, 5), (3, 4), (4, 3), (2, 2), (1, 1), or (0, 0).

According to a third aspect, an embodiment of this application provides a communication apparatus. The communication apparatus may be applied to the transmitter device in the first aspect or the second aspect, to implement a function performed by the transmitter device. The communication apparatus may be a transmitter device, or may be a chip, a chip system, a system on chip, or the like of the transmitter device. The communication apparatus may perform the function performed by the transmitter device by hardware, or by hardware executing corresponding software. The hardware or the software includes one or more modules corresponding to the foregoing function, for example, a transceiver module and a processing module. The transceiver module may independently complete the following receiving and sending operations, or may cooperate with the processing module to complete the following receiving and sending operations. Correspondingly, the processing module may independently complete the following processing operation, or may cooperate with the transceiver module to complete the following processing operation. This is not limited.

For example, the processing module is configured to map, based on a reliability sequence with a length of N, an information bit sequence with a length of k to k bit positions in a first sequence with a length of N, to obtain a second sequence. The second sequence includes k information bits, x parity check PC bits, and (N-k-x) frozen bits, and k, N, and x are all positive integers; m information bits in the k information bits are at first m bit positions in the second sequence sorted in descending order of reliability, and remaining (k-m) information bits in the k information bits are at bit positions that are in the second sequence and that correspond to first (k-m) information bits in a preset information bit set sorted in descending order of reliability; and the x PC bits are x PC bits in a preset PC bit set. The processing module is further configured to perform polar encoding on the second sequence to obtain a third sequence.

In another example, the processing module is configured to map, based on a reliability sequence with a length of N, an information bit sequence with a length of k to k bit positions in a first sequence with a length of N, to obtain a fourth sequence. The fourth sequence includes k information bits, 0 parity check PC bits, and (N-k) frozen bits, and both k and N are positive integers. The processing module is further configured to: perform polar encoding on the fourth sequence to obtain a fifth sequence; and perform rate matching on the fifth sequence in a front-to-back puncturing manner, to obtain a sixth sequence.

Optionally, the transceiver module and the processing module of the communication apparatus in the third aspect may further perform a corresponding function in the first aspect or any possible design of the first aspect, or perform a corresponding function in the second aspect or any possible design of the second aspect. For details, refer to the detailed descriptions in the method example. For beneficial effects that can be achieved, refer to the foregoing related content.

According to a fourth aspect, an embodiment of this application provides a communication apparatus. The communication apparatus includes one or more processors. The one or more processors are configured to run a computer program or instructions. When the one or more processors execute the computer instruction or the instructions, the polar code encoding method according to either the first aspect or the second aspect is performed.

In a possible design, the communication apparatus further includes one or more memories. The one or more memories are coupled to the one or more processors, and the one or more memories are configured to store the foregoing computer program or instructions. In a possible implementation, the memory is located outside the communication apparatus. In another possible implementation, the memory is located inside the communication apparatus. In this embodiment of this application, the processor and the memory may alternatively be integrated into one component. In other words, the processor and the memory may alternatively be integrated together. In a possible implementation, the communication apparatus further includes a transceiver. The transceiver is configured to receive information and/or send information.

In a possible design, the communication apparatus further includes one or more communication interfaces. The one or more communication interfaces are coupled to the one or more processors, and the one or more communication interfaces are configured to communicate with a module other than the communication apparatus.

According to a fifth aspect, an embodiment of this application provides a communication apparatus. The communication apparatus includes an interface circuit and a logic circuit. The interface circuit is configured to input and/or output information. The logic circuit is configured to perform the polar code encoding method according to either the first aspect or the second aspect, and perform processing based on the information and/or generate information based on the information.

According to a sixth aspect, an embodiment of this application provides a computer-readable storage medium. The computer-readable storage medium stores computer instructions or a program. When the computer instructions or the program is run on a computer, the polar code encoding method according to either the first aspect or the second aspect is performed.

According to a seventh aspect, an embodiment of this application provides a computer program product including computer instructions. When the computer program product is run on a computer, the polar code encoding method according to either the first aspect or the second aspect is performed.

According to an eighth aspect, an embodiment of this application provides a computer program. When the computer program is run on a computer, the polar code encoding method according to either the first aspect or the second aspect is performed.

According to a ninth aspect, an embodiment of this application provides a chip, including a processor. The processor is coupled to a memory. The memory is configured to store a program or instructions. When the program or the instructions are executed by the processor, the polar code encoding method according to either the first aspect or the second aspect is performed.

For technical effects brought by any design of the fourth aspect to the ninth aspect, refer to the technical effects brought by either the first aspect or the second aspect. Details are not described again.

According to a tenth aspect, an embodiment of this application provides a communication system. The communication system may include the communication apparatus configured to perform the first aspect or any possible design of the first aspect, or may include the communication apparatus configured to perform the second aspect or any possible design of the second aspect.

### BRIEF DESCRIPTION OF DRAWINGS

FIG. 1 is a diagram of an interleaving pattern search process according to an embodiment of this application;
FIG. 2 is a diagram of a communication system according to an embodiment of this application;
FIG. 3 is a diagram of encoding performed by a transmitter device and decoding performed by a receiver device according to an embodiment of this application;
FIG. 4 is a composition diagram of a communication apparatus according to an embodiment of this application;
FIG. 5 is a flowchart of a polar code encoding method according to an embodiment of this application;
FIG. 6A and FIG. 6B are diagrams of PC bits and information bits according to an embodiment of this application;
FIG. 7A and FIG. 7B are diagrams of PC bits and information bits according to an embodiment of this application;
FIG. 8 is a diagram of performance comparison according to an embodiment of this application;
FIG. 9 is a diagram of performance comparison according to an embodiment of this application;
FIG. 10 is a diagram of performance comparison according to an embodiment of this application;
FIG. 11 is a diagram of performance comparison according to an embodiment of this application;
FIG. 12 is a diagram of performance comparison according to an embodiment of this application;
FIG. 13 is a diagram of a polar code encoding method according to an embodiment of this application;
FIG. 14 is a diagram of information bits according to an embodiment of this application;
FIG. 15 is a diagram of performance comparison according to an embodiment of this application;
FIG. 16 is a diagram of performance comparison according to an embodiment of this application;
FIG. 17 is a diagram of performance comparison according to an embodiment of this application;
FIG. 18 is a diagram of performance comparison according to an embodiment of this application;
FIG. 19A to FIG. 19D are diagrams of performance comparison according to an embodiment of this application;
FIG. 20 is a diagram of a communication apparatus according to an embodiment of this application; and
FIG. 21 is a composition diagram of a communication apparatus according to an embodiment of this application.

### DESCRIPTION OF EMBODIMENTS

Before embodiments of this application are described, technical terms used in embodiments of this application are described.

Parity-check polar codes (parity-check polar codes, PC-polar codes): can effectively improve code spectrum performance of polar codes. The parity-check polar codes may include information bit positions, frozen bit positions, and parity check (parity check, PC) bit positions. The information bit position may be used to carry an information bit, the frozen bit position may be used to carry a frozen bit, and the PC bit position may be used to carry a PC bit.

Some of frozen bit positions may be selected as a set of PC bit positions. Values of PC bits at these PC bit positions are different from those of remaining frozen bits, that is, are not fixed to 0, but instead, are determined based on values of information bits at information bit positions before the PC bit positions by using a PC equation. Therefore, the PC bit position may also be referred to as a dynamic frozen bit position (that is, such position is from the frozen bit position, but a value is not fixed to 0).

New radio parity-check polar codes (new radio parity-check polar codes, NR PC-polar codes): A transmitter device may first perform rate matching, and then determine an information bit, a frozen bit, and a PC bit based on a code length that is after the rate matching and a code rate. After the PC bit is determined, an interval between the PC bit and an information bit checked by the PC bit is a fixed interval.

Before performing rate matching, the transmitter device may perform sub-block interleaving on a polar code sequence whose mother code length is N, and then perform rate matching on a sequence that is after the sub-block interleaving.

For example, the transmitter device may divide the polar code sequence whose mother code length is N into 32 sub-blocks with a same length, that is, a size of each sub-block is N/32. Then, sub-block interleaving is performed on a sub-block basis with reference to a sub-block interleaving pattern shown in Table 1 below, to obtain a sequence that is after the sub-block interleaving.

**Table 1 Sub-block interleaving pattern**

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 0 | 4 | 3 | 8 | 8 | 12 | 10 | 16 | 12 | 20 | 14 | 24 | 24 | 28 | 27 |
| 1 | 1 | 5 | 5 | 9 | 16 | 13 | 18 | 17 | 20 | 21 | 22 | 25 | 25 | 29 | 29 |
| 2 | 2 | 6 | 6 | 10 | 9 | 14 | 11 | 18 | 13 | 22 | 15 | 26 | 26 | 30 | 30 |
| 3 | 4 | 7 | 7 | 11 | 17 | 15 | 19 | 19 | 21 | 23 | 23 | 27 | 28 | 31 | 31 |

It may be understood that Table 1 is defined starting from bit 0, or may alternatively be defined starting from bit 1, that is, 0, 1, ..., and 31 may be respectively replaced with 1, 2, ..., and 32. This is not limited.

Based on the foregoing descriptions, after performing sub-block interleaving, the transmitter device may determine a corresponding rate matching manner based on a code rate R=K/E and a code length E that is after rate matching. K represents a length of an information bit sequence, or may be described as a quantity of information bits in a sequence. The code length E that is after rate matching may also be referred to as a sending length E.

For example, the transmitter device may determine the mother code length N=max(min([N_{M}, N_{R}, Nₘₐₓ]), 32) based on the length K of the information bit sequence and the code length E that is after rate matching. If E>N, it is determined that the rate matching manner is repetition (repetition). To be specific, after sending a mother code whose length is N, the transmitter device further sends (E-N) bits that are after sub-block interleaving. If E<N, the transmitter device may determine, based on a current code rate R, whether to perform front-to-back puncturing (puncture) or back-to-front shortening (shorten) based on a sequence that is after sub-block interleaving. If R<7/16, rate matching is performed in a front-to-back puncturing manner, that is, (N-E) bits in the sequence that is after sub-block interleaving are punctured from front to back. Otherwise, (N-E) bits in the sequence that is after sub-block interleaving are shortened from back to front.

N_{M} is related to the code rate R=K/E and N_{DM}, and ${N}_{DM} = {2}^{\left⌈{log}_{2}E\right⌉}$. Tf E≤9/8×N_{DM} and R<9/16, N_{M}=N_{DM}/2; otherwise, N_{M}=N_{DM}. N_{R} is related to K and a minimum code rate Rₘᵢₙ, where ${N}_{R} = {2}^{\left⌈\frac{K}{{R}_{min}}\right⌉}$, and Rₘᵢₙ=1/8. Nₘₐₓ=1024.

Based on the foregoing descriptions, a rate matching manner of an NR PC-polar code is related to specific values of K and E. This means that information bits, PC bits, and frozen bits corresponding to different values of K and E are different, and cannot be nested.

Nested PC-polar codes: Different from the NR PC-polar codes, for the nested PC-polar codes, information bits, frozen bits, and PC bits are independent of a code length after rate matching and a code rate. Sequences of different quantities K of information bits or different sending lengths E (that is, code lengths after rate matching is performed on a mother code length) correspond to a same PC bit and PC equation. The PC bits and the PC equations do not change with K or E, in other words, the PC bits and the PC equations of the nested PC-polar code are nested. For the nested PC-polar codes, the information bits, the frozen bits, and the PC bits may be first determined, to ensure optimal performance of using a same PC equation for sequences of different quantities of information bits under a mother code length, then followed by rate matching.

The rate matching scheme of the nested PC-polar codes is based on performance-oriented, nested puncturing sequence approaches, and is designed individually for each (K, E) pair, achieving fine granularity and good performance. The following provides a rate matching procedure, of the nested PC-polar codes, obtained through a performance search:

Step 1: Perform interleaving on an input sequence ${d}_{0}^{31}$ at an initial stage of rate matching, to obtain an interleaved sequence eₙ = e₀, e₁, e₂, ... , e_{N-1}.${d}_{0}^{31} = {c}_{0}^{31}$, and ${c}_{0}^{31}$ is a sequence, of the nested PC-polar code, whose length is the mother code length.

For example, interleaving may be performed on the input sequence by using an interleaving pattern P(n) shown in Table 2 below. The interleaved sequence eₙ may be obtained in the following manner:

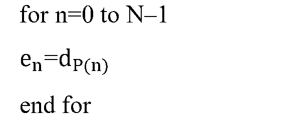

**Table 2 Interleaving pattern**

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 29 | 4 | 19 | 8 | 14 | 12 | 0 | 16 | 12 | 20 | 24 | 24 | 16 | 28 | 9 |
| 1 | 20 | 5 | 22 | 9 | 4 | 13 | 13 | 17 | 3 | 21 | 10 | 25 | 30 | 29 | 11 |
| 2 | 18 | 6 | 23 | 10 | 1 | 14 | 8 | 18 | 6 | 22 | 21 | 26 | 7 | 30 | 26 |
| 3 | 15 | 7 | 25 | 11 | 2 | 15 | 17 | 19 | 27 | 23 | 31 | 27 | 28 | 31 | 5 |

It may be understood that Table 2 is defined starting from bit 0, or may alternatively be defined starting from bit 1, that is, 0, 1, ..., and 31 may be respectively replaced with 1, 2, ..., and 32. This is not limited.

Step 2: Perform a rate matching operation on the interleaved sequence eₙ, where an output sequence after the rate matching is f₀,f₁,f₂, ... , f_{E-1}.

E is a code length after the rate matching.

For example, the output sequence f₀,f₁,f₂, ... , f_{E-1} may be obtained in the following manner:

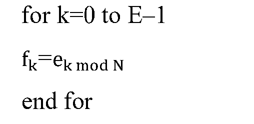

Based on the foregoing descriptions of the interleaving pattern corresponding to the nested PC-polar code, a search algorithm may be designed to determine, based on sequence performance and a nesting property, the interleaving pattern corresponding to the nested PC-polar code. In other words, the interleaving pattern corresponding to the nested PC-polar code has a nesting property for sequences of different quantities of information bits, and does not change with a length of the information bit sequence. This can greatly reduce complexity while ensuring optimal performance and nesting property of the sequence.

For example, a List search algorithm may be used to search for a puncturing position on a plurality of sequence samples (the plurality of sequence samples may correspond to information bit sequences of different lengths, and a length of each information bit sequence is less than or equal to K). Each time a quantity of to-be-punctured positions is increased by 1, average sequence performance of all sequences is calculated. The average sequence performance is used as a metric (Metric). A position corresponding to optimal average sequence performance is determined as a to-be-punctured position, to generate the interleaving pattern corresponding to the nested PC-polar code. The average performance may be a mean of SNRs required to reach BLER=1E-2 over the sequence, where SNR represents a signal-to-noise ratio (signal-to-noise ratio), and BLER represents a block error rate (block error rate).

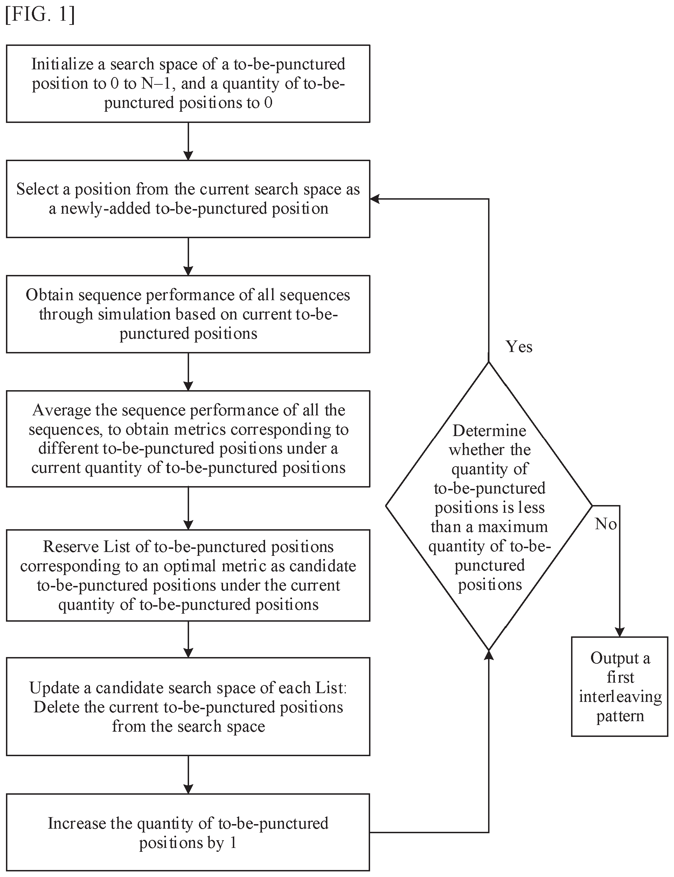

Optionally, the interleaving pattern corresponding to the nested PC-polar code may be determined with reference to a performance search process shown in FIG. 1.

Step 1: Initialize a search space of a to-be-punctured position to 0 to N-1, and a quantity of to-be-punctured positions to 0.

Step 2: Select a position from the current search space as a newly-added to-be-punctured position.

Step 3: Obtain sequence performance of all sequences through simulation based on current to-be-punctured positions.

Step 4: Average the sequence performance of all the sequences, to obtain metrics corresponding to different to-be-punctured positions under a current quantity of to-be-punctured positions.

Step 5: Reserve List of to-be-punctured positions corresponding to an optimal metric as candidate to-be-punctured positions under the current quantity of to-be-punctured positions.

Step 6: Update a candidate search space of each List: Delete the current to-be-punctured positions from the search space.

Step 7: Increase the quantity of to-be-punctured positions by 1.

Step 8: Determine whether the quantity of to-be-punctured positions is less than a maximum quantity of to-be-punctured positions. If the quantity of to-be-punctured positions is less than the maximum quantity of to-be-punctured positions, continue to perform step 2 until the quantity of to-be-punctured positions is equal to the maximum quantity of to-be-punctured positions. If the quantity of to-be-punctured positions is not less than the maximum quantity of to-be-punctured positions, output the interleaving pattern (or may be referred to as an optimal puncturing pattern) corresponding to the nested PC-polar code.

Based on the foregoing descriptions, the rate matching scheme of the nested PC-polar codes is based on performance-oriented, nested puncturing sequence approaches, and therefore cannot reuse a sub-block interleaving rate matching approach of NR PC-polar codes, leading to poor NR compatibility.

To resolve the foregoing problems existing in the NR PC-polar code and the nested PC-polar code, an embodiment of this application provides the following scheme: A transmitter device may map, based on a reliability sequence with a length of N, an information bit sequence with a length of k to k bit positions in a first sequence with a length of N, to obtain a second sequence, where the second sequence includes k information bits, x parity check PC bits, and (N-k-x) frozen bits, and k, N, and x are all positive integers; m information bits in the k information bits are at first m bit positions in the second sequence sorted in descending order of reliability, and remaining (k-m) information bits in the k information bits are at bit positions that are in the second sequence and that correspond to first (k-m) information bits in a preset information bit set sorted in descending order of reliability; and the x PC bits are x PC bits in a preset PC bit set; and perform polar encoding on the second sequence to obtain a third sequence.

This embodiment of this application provides a polar code encoding scheme with a nesting property. For sequences of different quantities of information bits, a polar code may be constructed based on the same m information bits, the preset information bit set, and the preset PC bit set. The m information bits, the preset information bit set, and the preset PC bit set have a nesting property for the sequences of different quantities of information bits, and do not change with the quantity of information bits in the sequence. In addition, a sub-block interleaving rate matching manner of an NR PC-polar code may be reused for the PC-polar code having the nesting property obtained based on the m information bits, the preset information bit set, and the preset PC bit set. The PC-polar code having the nesting property still has good rate matching performance in the sub-block interleaving rate matching manner of the NR PC-polar code. This can simplify a rate matching operation, improve NR compatibility, and improve communication performance.

The following describes implementations of embodiments of this application in detail with reference to accompanying drawings in this specification.

A polar code encoding method provided in embodiments of this application may be applied to any communication system. The communication system may be a 3rd generation partnership project (3rd generation partnership project, 3GPP) communication system, for example, a long term evolution (long term evolution, LTE) system, or may be a 5th generation (5th generation, 5G) mobile communication system, an LTE and 5G hybrid networking system, an NR system, an NR vehicle to everything (vehicle to everything, V2X) system, a device-to-device (device-to-device, D2D) communication system, a machine to machine (machine to machine, M2M) communication system, internet of things (internet of things, IoT), a narrowband-internet of things (narrowband-internet of things, NB-IoT) system, a global system for mobile communications (global system for mobile communications, GSM), an enhanced data rates for GSM evolution (enhanced data rates for GSM evolution, EDGE) system, a wideband code division multiple access (wideband code division multiple access, WCDMA) system, a code division multiple access 2000 (code division multiple access, CDMA2000) system, a time division-synchronous code division multiple access (time division-synchronous code division multiple access, TD-SCDMA) system, an enhanced mobile broadband (enhanced mobile broadband, eMBB), ultra-reliable and low-latency communication (ultra-reliable and low-latency communication, URLLC), enhanced machine-type communication (enhanced machine-type communication, eMTC), and various types of next-generation communication systems, such as a 6th generation (6th generation, 6G) mobile communication system, or may be a non-terrestrial network (non-terrestrial network, NTN) system, a non-3GPP communication system, or the like. This is not limited.

The polar code encoding method provided in embodiments of this application may be applied to various communication scenarios, and is particularly applicable to a channel coding scenario in which a polar code is used as a short code in a communication system. For example, the polar code encoding method may be applied to one or more of the following communication scenarios: control channel coding, data channel coding, and the like. This is not limited.

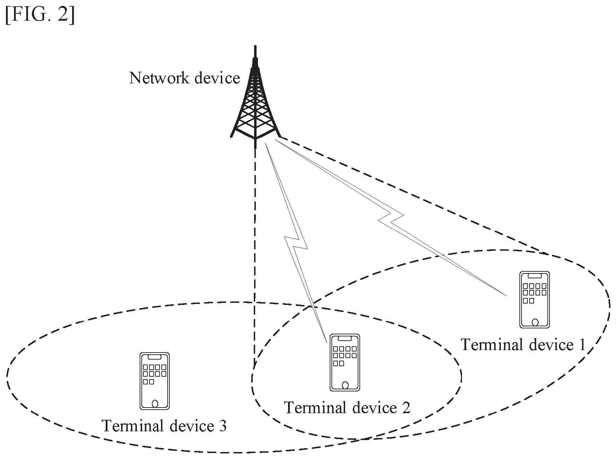

The following uses FIG. 2 as an example to describe a communication system provided in an embodiment of this application.

FIG. 2 is a diagram of a communication system according to an embodiment of this application. As shown in FIG. 2, the communication system may include at least one terminal device and at least one network device.

In FIG. 2, the terminal device may be located in beam/cell coverage of the network device, and the network device may provide a communication service for the terminal device. For example, the network device may encode downlink data through channel encoding, and transmit the downlink data to the terminal device through an air interface after constellation modulation (that is, the network device is a transmitter device, and the terminal device is a receiver device). The terminal device may encode uplink data through channel encoding, and send the uplink data to the network device through an air interface after constellation modulation (that is, the terminal device is a transmitter device, and the network device is a receiver device). It may be understood that, when the network device communicates with another network device, or the terminal device communicates with another terminal device, communication may be performed based on channel encoding. In other words, both the transmitter device and the receiver device may be network devices, or both may be terminal devices. This is not limited.

The terminal device in FIG. 2 may be a device having a wireless transceiver function or a chip or a chip system that can be disposed in the device, allowing a user to access a network, and is a device configured to provide voice and/or data connectivity for the user. The terminal device may also be referred to as user equipment (user equipment, UE), a subscriber unit (subscriber unit), a terminal (terminal), a mobile station (mobile station, MS), a mobile terminal (mobile terminal, MT), or the like.

For example, the terminal device in FIG. 2 may be a mobile phone (mobile phone), a tablet computer, or a computer with a wireless transceiver function. Alternatively, the terminal device may be a user station, a mobile station, a remote station, a remote terminal device, a mobile terminal device, a user terminal device, a wireless communication device, a user agent, a user apparatus, a cellular phone, a cordless phone, a session initiation protocol (session initiation protocol, SIP) phone, a wireless local loop (wireless local loop, WLL) station, a personal digital processing (personal digital assistant, PDA), a handheld device having a wireless communication function, a computing device, a processing device connected to a wireless modem, a vehicle-mounted device, a wearable device, a terminal device in the internet of things, household appliance, a virtual reality (virtual reality, VR) terminal, an augmented reality (augmented reality, AR) terminal, a wireless terminal in industrial control, a wireless terminal in unmanned driving, a wireless terminal in telemedicine, a wireless terminal in a smart grid, a wireless terminal in a smart city (smart city), a wireless terminal in a smart home (smart home), a vehicle having a vehicle-to-vehicle (vehicle-to-vehicle, V2V) communication capability, an intelligent connected vehicle, an uncrewed aerial vehicle having an uncrewed aerial vehicle to uncrewed aerial vehicle (UAV to UAV, U2U) communication capability, a terminal device in a future network, a terminal device in a future evolved public land mobile network (public land mobile network, PLMN), or the like. This is not limited.

The network device in FIG. 2 may be any device that is deployed in an access network and that can perform wireless communication with a terminal device, or may be a chip or a chip system that may be disposed in the device, or may be a logical node or a logical module or a function implemented by software, and may be configured to implement functions such as a radio physical control function, resource scheduling and radio resource management, radio access control, and mobility management. Specifically, the network device may be a device supporting wired access, or may be a device supporting wireless access.

For example, the network device may include one or more access network (access network, AN)/radio access network (radio access network, RAN) nodes. The AN/RAN node may be a continuously evolved NodeB (gNB), a transmission reception point (transmission reception point, TRP), an evolved NodeB (evolved NodeB, eNB), a radio network controller (radio network controller, RNC), a NodeB (NodeB, NB), a base station controller (base station controller, BSC), a base transceiver station (base transceiver station, BTS), a home base station (for example, a home evolved NodeB or a home NodeB, HNB), a baseband unit (baseband unit, BBU), a wireless fidelity (wireless fidelity, Wi-Fi) access point (access point, AP), or the like.

In another example, the network device may include a baseband unit (baseband unit, BBU) and a remote radio unit (remote radio unit, RRU). The BBU and the RRU may be placed at different places. For example, the RRU is remotely deployed, and placed in a heavy-traffic area, and the BBU is placed in a central equipment room. Alternatively, the BBU and the RRU may be placed in a same equipment room. Alternatively, the BBU and the RRU may be different components at a same rack.

In still another example, the network device may be a device including a central unit (central unit, CU) node or a distributed unit (distributed unit, DU) node, or including both a CU node and a DU node. For example, the network device may be divided into a CU and a DU from a perspective of logical functions. Some protocol layer functions are centrally controlled by the CU, and remaining or all protocol layer functions are distributed in the DU, and the CU centrally controls the DU. Further, the central unit CU may be further divided into a control plane (CU-CP) and a user plane (CU-UP). In different systems, a CU (including a CU-CP or a CU-UP) or a DU may have different names. For example, in an open radio access network (open radio access network, O-RAN) system, the CU may also be referred to as an O-CU (open CU), the DU may also be referred to as an O-DU, the CU-CP may also be referred to as an O-CU-CP, and the CU-UP may also be referred to as an O-CU-UP.

Based on the foregoing descriptions of the terminal device and the network device, optionally, the polar code encoding method provided in embodiments of this application may be implemented by the terminal device or the network device, or may be implemented by a component or the like of the terminal device or the network device, for example, an application-specific integrated circuit (application-specific integrated circuit, ASIC), a field programmable gate array (field programmable gate array, FPGA), or software (for example, program code in a memory) deployed in the terminal device or the network device. This is not limited.

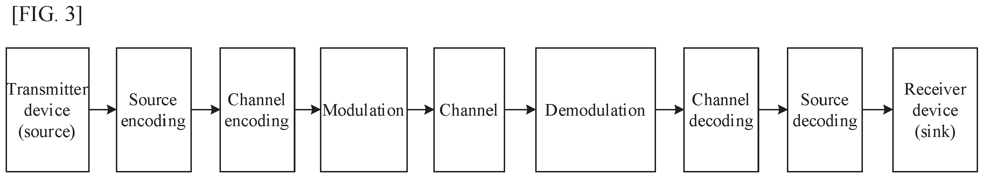

Optionally, in embodiments of this application, the transmitter device (or referred to as a source) and the receiver device (or referred to as a sink) may perform encoding and decoding by following a procedure shown in FIG. 3.

The transmitter device may perform source encoding on bits generated by the transmitter device, to obtain a source bit stream, perform channel encoding on the source bit stream, perform modulation, and then send a modulated symbol to the receiver device through a noisy channel. When receiving the modulated symbol through the noisy channel, the receiver device may perform demodulation, then perform channel decoding to restore the source bit stream, and perform source decoding to obtain a decoding result.

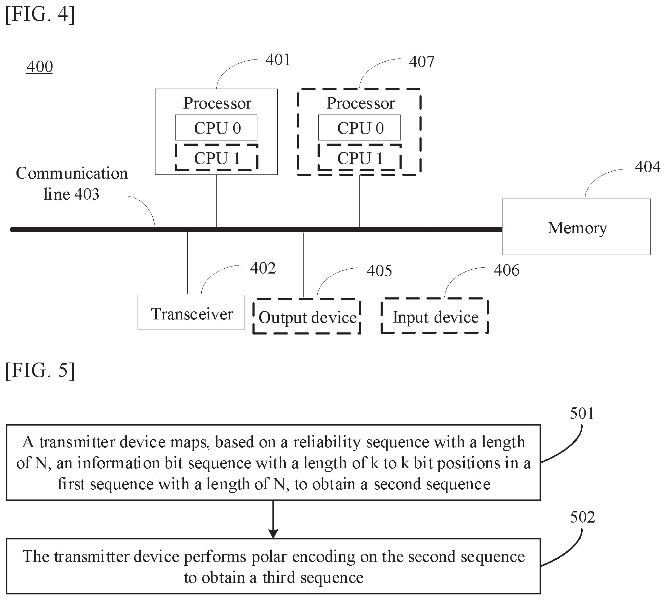

During specific implementation, as shown in FIG. 2, for example, each terminal device or network device may use a composition structure shown in FIG. 4, or include components shown in FIG. 4. FIG. 4 is a composition diagram of a communication apparatus 400 according to an embodiment of this application. The communication apparatus 400 may be a terminal device or a chip or a system-on-a-chip in the terminal device, or may be a network device or a chip or a system-on-a-chip in the network device. As shown in FIG. 4, the communication apparatus 400 includes a processor 401, a transceiver 402, and a communication line 403.

Further, the communication apparatus 400 may include a memory 404. The processor 401, the memory 404, and the transceiver 402 may be connected through the communication line 403.

The processor 401 is a central processing unit (central processing unit, CPU), a general purpose processor, a network processor (network processor, NP), a digital signal processor (digital signal processor, DSP), a microprocessor, a microcontroller, a programmable logic device (programmable logic device, PLD), or any combination thereof. The processor 401 may alternatively be another apparatus having a processing function, for example, a circuit, a component, or a software module. This is not limited.

The transceiver 402 is configured to communicate with another device or another communication network. The another communication network may be an Ethernet, a radio access network (radio access network, RAN), a wireless local area network (wireless local area network, WLAN), or the like. The transceiver 402 may be a module, a circuit, a transceiver, or any apparatus that can implement communication.

The communication line 403 is configured to transmit information between the components included in the communication apparatus 400.

The memory 404 is configured to store instructions. The instructions may be computer programs.

The memory 404 may be a read-only memory (read-only memory, ROM) or another type of static storage device that can store static information and/or instructions, may be a random access memory (random access memory, RAM) or another type of dynamic storage device that can store information and/or instructions, or may be an electrically erasable programmable read-only memory (electrically erasable programmable read-only memory, EEPROM), a compact disc read-only memory (compact disc read-only memory, CD-ROM) or another compact disc storage, an optical disc storage (including a compressed optical disc, a laser disc, an optical disc, a digital universal optical disc, a Blu-ray optical disc, or the like), a magnetic disk storage medium or another magnetic storage device, or the like. This is not limited.

It should be noted that the memory 404 may be independent of the processor 401, or may be integrated with the processor 401. The memory 404 may be configured to store instructions, program code, some data, or the like. The memory 404 may be located inside the communication apparatus 400, or may be located outside the communication apparatus 400. This is not limited. The processor 401 is configured to execute the instructions stored in the memory 404, to implement the polar code encoding method provided in the following embodiments of this application.

In an example, the processor 401 may include one or more CPUs, for example, a CPU 0 and a CPU 1 in FIG. 4.

In an optional implementation, the communication apparatus 400 includes a plurality of processors. For example, the communication apparatus 400 may further include a processor 407 in addition to the processor 401 in FIG. 4.

In an optional implementation, the communication apparatus 400 further includes an output device 405 and an input device 406. For example, the input device 406 is a keyboard, a mouse, a microphone, a joystick, or another device, and the output device 405 is a display, a speaker (speaker), or another device.

It should be noted that the communication apparatus 400 may be a desktop computer, a portable computer, a network server, a mobile phone, a tablet computer, a wireless terminal, an embedded device, a chip system, or a device having a structure similar to that in FIG. 4. In addition, the composition structure shown in FIG. 4 does not constitute a limitation on the communication apparatus. In addition to the components shown in FIG. 4, the communication apparatus may include more or fewer components than those shown in the figure, combine some components, or have different component arrangements.

In this embodiment of this application, the chip system may include a chip, or may include a chip and another discrete device.

In addition, for operations, terms, and the like in embodiments of this application, refer to each other. This is not limited. In embodiments of this application, names of messages exchanged between devices, names of parameters in the messages, or the like are merely examples. Other names may alternatively be used during specific implementation. This is not limited.

With reference to the communication system shown in FIG. 2, the following describes a polar code encoding method provided in an embodiment of this application with reference to FIG. 5. A transmitter device may be any terminal device or network device in the communication system shown in FIG. 2, and a receiver device may also be any terminal device or network device in the communication system shown in FIG. 2. The transmitter device or the receiver device described in the following embodiment may have the components shown in FIG. 4.

FIG. 5 is a flowchart of a polar code encoding method according to an embodiment of this application. As shown in FIG. 5, the method may include the following steps.

Step 501: A transmitter device maps, based on a reliability sequence with a length of N, an information bit sequence with a length of k to k bit positions in a first sequence with a length of N, to obtain a second sequence.

The reliability sequence may be used to indicate reliability corresponding to each bit position in the sequence. A larger value of the reliability indicates higher reliability of a bit position corresponding to the reliability. A length of the reliability sequence may be N, and N is a positive integer.

Optionally, the reliability sequence may be an NR reliability sequence.

For example, the length N of the reliability sequence is 32. The reliability sequence may be a reliability sequence shown in Table 3 below, where $W \left({Q}_{i}^{Nmax}\right)$ represents reliability, and ${Q}_{i}^{Nmax}$ represents a bit position corresponding to reliability.

**Table 3 Reliability sequence**

| $W \left({Q}_{i}^{Nmax}\right)$ | ${Q}_{i}^{Nmax}$ | $W \left({Q}_{i}^{Nmax}\right)$ | ${Q}_{i}^{Nmax}$ | $W \left({Q}_{i}^{Nmax}\right)$ | ${Q}_{i}^{Nmax}$ | $W \left({Q}_{i}^{Nmax}\right)$ | ${Q}_{i}^{Nmax}$ |
|---|---|---|---|---|---|---|---|
| 0 | 0 | 8 | 9 | 16 | 7 | 24 | 22 |
| 1 | 1 | 9 | 6 | 17 | 11 | 25 | 28 |
| 2 | 2 | 10 | 17 | 18 | 19 | 26 | 15 |
| 3 | 4 | 11 | 10 | 19 | 13 | 27 | 23 |
| 4 | 8 | 12 | 18 | 20 | 14 | 28 | 27 |
| 5 | 16 | 13 | 12 | 21 | 21 | 29 | 29 |
| 6 | 3 | 14 | 20 | 22 | 26 | 30 | 30 |
| 7 | 5 | 15 | 24 | 23 | 25 | 31 | 31 |

It may be understood that Table 3 is defined starting from bit 0, or may alternatively be defined starting from bit 1, that is, 0, 1, ..., and 31 may be respectively replaced with 1, 2, ..., and 32. This is not limited.

Refer to the foregoing reliability sequence. The transmitter device may map the information bit sequence with a length of k to the k bit positions in the first sequence with a length of N, to obtain the second sequence.

The second sequence may include k information bits, x parity check PC bits, and (N-k-x) frozen bits, and k, N, and x are all positive integers; m information bits in the k information bits are at first m bit positions in the second sequence sorted in descending order of reliability, and remaining (k-m) information bits in the k information bits are at bit positions that are in the second sequence and that correspond to first (k-m) information bits in a preset information bit set sorted in descending order of reliability; and the x PC bits are x PC bits in a preset PC bit set.

For example, the length k of the information bit sequence may be any one of the following values: 7, 8, 9, 10, or 11.

Optionally, a specific value of m may be determined based on a row weight and reliability.

For example, a quantity of bit positions corresponding to one or more row weights may be determined as the specific value of m based on a descending order of reliability. For example, the value of m may be 6.

For example, the descending order of reliability is the order shown in Table 3. A row weight corresponding to a bit position 31 is 32, a row weight corresponding to bit positions (30, 29, 27, 23, 15) is 16, and a row weight corresponding to bit positions (28, 22, 25, 26, 21, 14, 13, 19, 11, 7) is 8. A quantity of bit positions corresponding to two top-ranked row weights may be determined as the specific value of m based on the descending order of reliability. In other words, the quantity 6 of bit positions corresponding to the row weights 32 and 16 may be determined as the value of m, that is, m is equal to 6.

It may be understood that the transmitter device may determine the specific value of m based on the row weight and the reliability. Alternatively, the specific value of m may be predefined in a protocol. The transmitter device determines the specific value of m based on pre-definition in the protocol. This is not limited.

Based on the foregoing descriptions of the value of m, the transmitter device may determine the m information bits in the second sequence based on the specific value of m and the reliability sequence.

For example, N is 32, m is 6, and the reliability sequence is the reliability sequence shown in Table 3. The m information bits in the k information bits may be at first six bit positions in the second sequence sorted in descending order of reliability, that is, the m information bits may be at the following bit positions in the second sequence: 15, 23, 27, 29, 30, and 31.

Based on the foregoing descriptions of the m information bits, the m information bits have a nesting property for sequences of different quantities (for example, k is equal to 7, 8, 9, 10, or 11) of information bits, and do not change with a length of the information bit sequence. This reduces decoding complexity, and improves decoding performance.

Optionally, the preset information bit set and the preset PC bit set may be determined based on the row weight and the reliability.

For an NR PC-polar code, if a quantity, of PC bits, that is predefined in the protocol and that needs to be determined is n_{PC}, a minimum row weight wₘᵢₙ corresponding to the k information bits may be first determined. If a quantity of remaining bit positions, in a bit position set that corresponds to the minimum row weight and that has information bits with a same row weight removed, is greater than or equal to n_{PC}, first n_{PC} positions sorted in descending order of reliability may be selected from the bit position set corresponding to the minimum row weight as PC bits, and information bits with the same row weight are shifted to bit positions with relatively low reliability. If the quantity of remaining bit positions is less than n_{PC}, first *n_{wmin}* bit positions sorted in descending order of reliability are selected from the bit position set corresponding to the minimum row weight as PC bits, and first (n_{PC}-*n_{wmin}*) bit positions sorted in ascending order of reliability may be selected from (K+n_{PC}) bit positions based on the reliability as remaining (n_{PC}-*n_{wmin}*) PC bits.

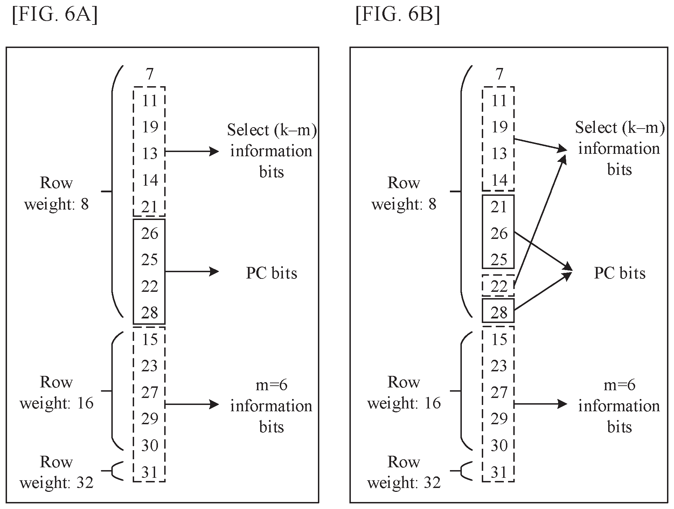

For example, as shown in FIG. 6A, the protocol-predefined quantity n_{PC}, of PC bits, that needs to be determined is 4 and the quantity k of information bits is 10. Row weights corresponding to the 10 information bits include 32, 16, and 8, and a quantity of information bits corresponding to the row weights 32 and 16 is 6. A minimum row weight wₘᵢₙ corresponding to the 10 information bits is 8. A bit position set corresponding to the minimum row weight 8 includes 10 bit positions (28, 22, 25, 26, 21, 14, 13, 19, 11, 7). The bit position set needs to include 10-6=4 information bits. After information bits with a same row weight are removed (that is, four information bits are removed) from the bit position set, a quantity of remaining bit positions is 6, which is greater than n_{PC}. Therefore, first n_{PC} positions sorted in descending order of reliability may be selected from the bit position set corresponding to the minimum row weight 8 as PC bits, that is, bit positions 28, 22, 25, and 26 may be used as PC bits. Information bits with the same row weight are shifted to bit positions with relatively low reliability. In other words, four bit positions in bit positions 21, 14, 13, 19, 11, and 7 may be determined as information bits.

However, if a sub-block interleaving-based rate matching manner featuring front-to-back puncturing in Table 1 is used, as the bit position 7 is relatively near to a start of the sequence, when E=24, 23, 22, 21, 20, 19, or 18, the bit position 7 is punctured. Therefore, the bit position 7 is pre-frozen. The bit position 7 in the second sequence may be set as a frozen bit (or may be referred to as a pre-frozen bit). Therefore, for the second sequence determined based on the information bit sequence with a length of k, six bit positions corresponding to the row weights 32 and 16 may be determined as m=6 information bits, and (k-m) bit positions are selected as information bits from a bit position set (21, 14, 13, 19, 11) corresponding to the row weight of 8.

However, when k is greater than or equal to 8, corresponding performance of PC bits and information bits determined in the foregoing manner still needs to be improved. Therefore, the manner of selecting the PC bits and the information bits may be changed. To be specific, the x PC bits in the second sequence may be determined based on the preset PC bit set, and the (k-m) information bits in the second sequence may be determined based on the preset information bit set, to improve decoding performance and rate matching performance.

For example, as shown in FIG. 6B, the preset PC bit set may correspond to the following bit positions in the second sequence: 21, 26, 25, and 28. The preset information bit set may correspond to the following bit positions in the second sequence: 11, 19, 13, 14, and 22.

Optionally, a difference between indexes of any two bit positions checked by any one PC bit in the preset PC bit set is not 1.

For example, k=9. The information bits in the second sequence may include 13, 14, 22, 15, 23, 27, 29, 30, and 31. Compared with a case in which the bit positions checked by the PC bit include 13 and 14 (or include 14 and 15), in a case in which the bit positions checked by the PC bit include either 13 or 14 (or include either 14 or 15), performance of the PC bit and the information bit can be greatly improved. In other words, when the difference between indexes of any two bit positions checked by any one PC bit in the preset PC bit is not 1, decoding performance and rate matching performance can be improved.

Optionally, an interval between the PC bit and the bit position checked by the PC bit may be a prime number, or may be an even number. This is not limited.

For example, k=11, the information bits in the second sequence may include 11, 19, 13, 14, 22, 15, 23, 27, 29, 30 and 31, and the PC bit is 21. For the bit position 11, an interval between the PC bit 21 and the bit position 11 is not a prime number. However, better performance can be achieved when the PC bit 21 checks the bit position 11. In other words, the interval between the PC bit and the information bit checked by the PC bit may alternatively be an even number, to improve decoding performance and rate matching performance.

Optionally, the bit position checked by the PC bit may be an information bit in the second sequence, or may be a frozen bit in the second sequence. This is not limited.

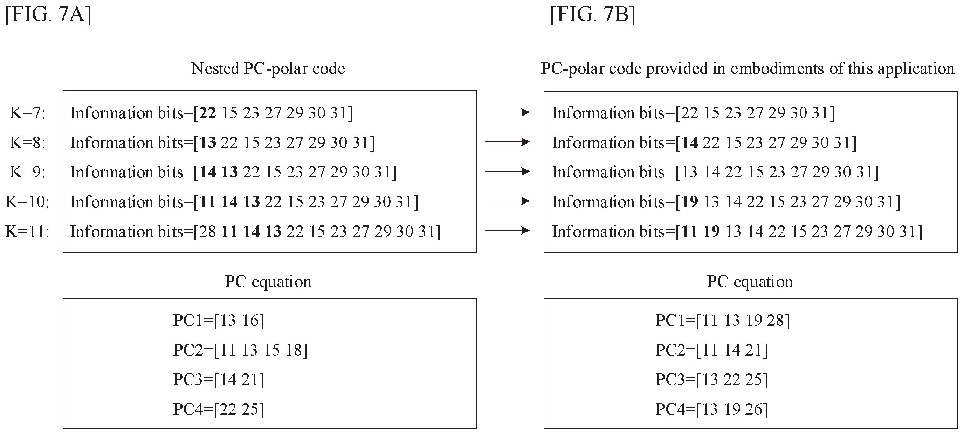

Based on the foregoing descriptions of the PC bit and the bit position checked by the PC bit, for example, according to a PC equation shown in FIG. 7B, when the PC bit is at the 21^{st} bit position in the second sequence, a bit position checked by the PC bit is one or more of the following bit positions in the second sequence: 11, and 14. Alternatively, when the PC bit is at the 26^{th} bit position in the second sequence, a bit position checked by the PC bit may be one or more of the following bit positions in the second sequence: 13 and 19. Alternatively, when the PC bit is at the 25^{th} bit position in the second sequence, a bit position checked by the PC bit may be one or more of the following bit positions in the second sequence: 13 and 22. Alternatively, when the PC bit is at the 28^{th} bit position in the second sequence, a bit position checked by the PC bit may be one or more of the following bit positions in the second sequence: 11, 13, and 19.

Compared with information bits, PC bits, and a PC equation corresponding to a nested PC-polar code shown in FIG. 7A, information bits, PC bits, and the PC equation that are shown in FIG. 7B and that are provided in this embodiment of this application are compatible with the sub-block interleaving rate matching manner of the NR PC-polar code while meeting a nesting property, thereby improving decoding performance and rate matching performance.

Based on the foregoing descriptions of the preset PC bit set, the PC equation, and the preset information bit set, the preset PC bit set, the PC equation, and the preset information bit set have a nesting property for sequences of different quantities (for example, k is equal to 7, 8, 9, 10, or 11) of information bits, and do not change with a length of the information bit sequence.

Based on the foregoing descriptions of the information bits and the PC bits, optionally, the transmitter device may sequentially map the information bit sequence with a length of k to the k information bits in the first sequence based on the reliability sequence, and set values of remaining (N-k) bit positions (including the x PC bits and the (N-k-x) frozen bits) in the first sequence to 0, to obtain the second sequence.

For example, a value of x may be 4.

For example, N=32 and k=11. The transmitter device may map an information bit sequence with a length of 11 to the following 11 information bits in the first sequence: (11, 19, 13, 14, 22, 15, 23, 27, 29, 30, 31), set four PC bits (21, 26, 25, 28) in the first sequence to 0, and set remaining 17 frozen bits to 0, to obtain the second sequence.

Step 502: The transmitter device performs polar encoding on the second sequence to obtain a third sequence.

The transmitter device may multiply the second sequence by a polar encoding matrix, to obtain the third sequence.

Optionally, the transmitter device may further perform rate matching on the third sequence in the sub-block interleaving rate matching manner of the NR PC-polar code.

The transmitter device may perform, with reference to the sub-block interleaving pattern shown in Table 1, sub-block interleaving on the third sequence on a sub-block basis, to obtain a sequence that is after the sub-block interleaving, and perform rate matching on the sequence that is after the sub-block interleaving.

Based on the method shown in FIG. 5, a polar code encoding scheme with a nesting property is provided. For sequences of different quantities of information bits, a polar code may be constructed based on the same m information bits, the preset information bit set, and the preset PC bit set. The m information bits, the preset information bit set, and the preset PC bit set have a nesting property for the sequences of different quantities of information bits, and do not change with the quantity of information bits in the sequence. In addition, the sub-block interleaving rate matching manner of the NR PC-polar code may be reused for the PC-polar code having the nesting property obtained based on the m information bits, the preset information bit set, and the preset PC bit set. The PC-polar code having the nesting property still has good rate matching performance in the sub-block interleaving rate matching manner of the NR PC-polar code. This can simplify a rate matching operation, improve NR compatibility, and improve communication performance.

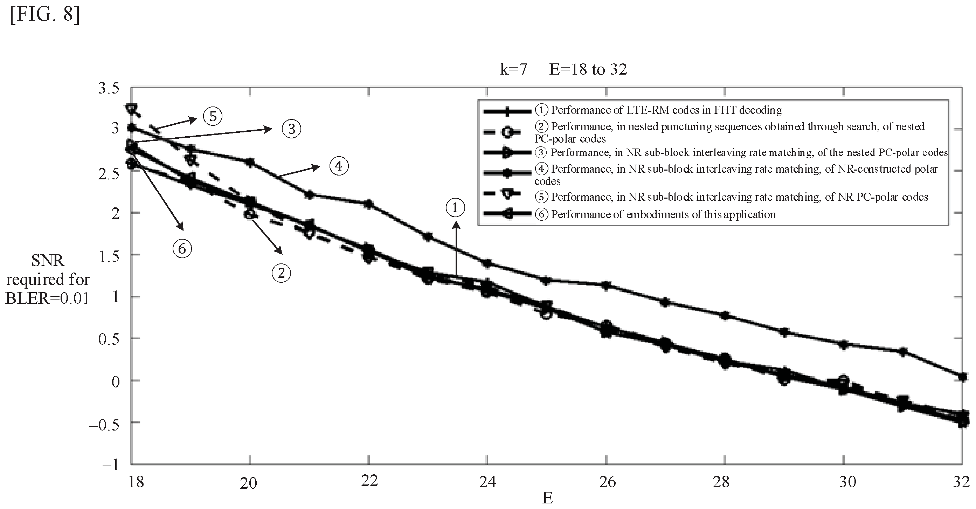

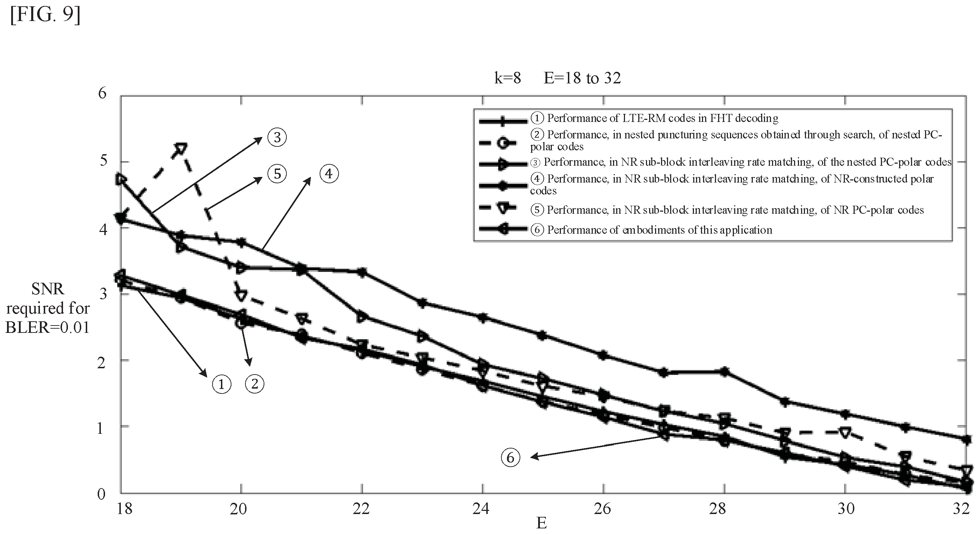

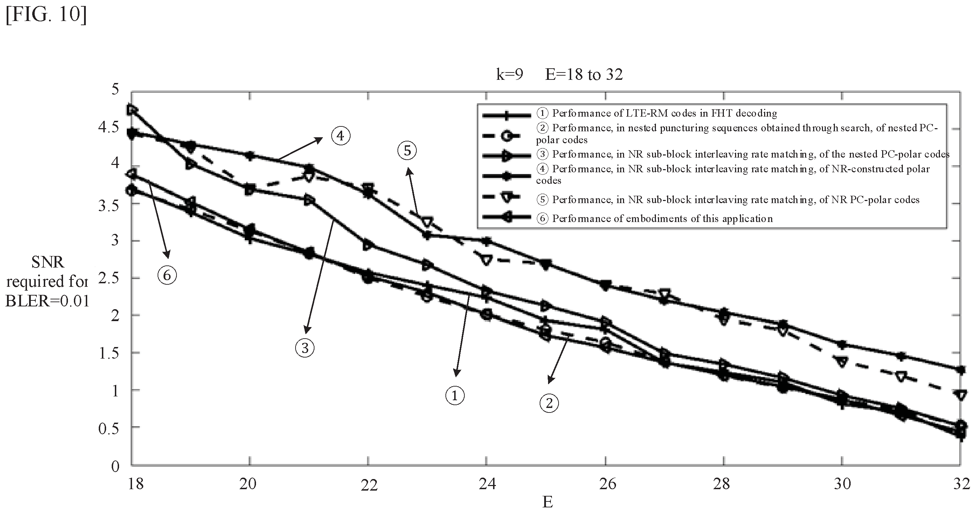

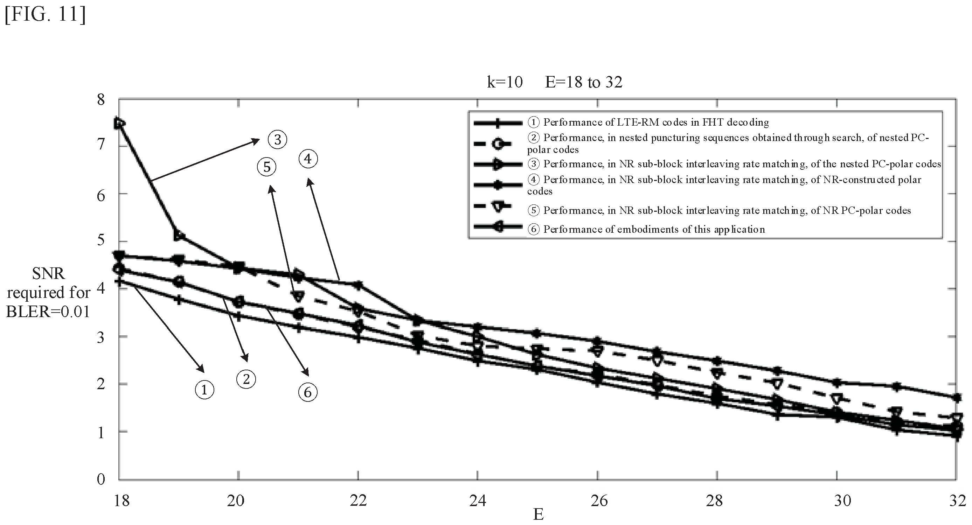

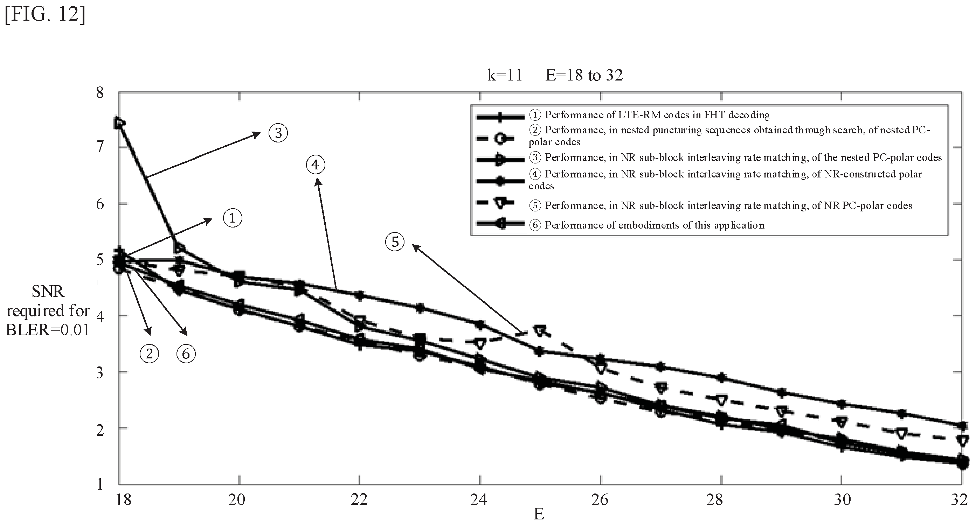

Optionally, based on the method shown in FIG. 5, the following FIG. 8 to FIG. 12 separately provide rate matching performance comparison between different short code schemes (for example, the length of the information bit sequence is 7, 8, 9, 10, or 11). A cross mark represents performance of an LTE-RM code in FHT decoding. A circle mark represents performance, in nested puncturing sequences obtained through search, of nested PC-polar codes obtained through search. A curve of rightward-pointing triangular marks represents performance, in NR sub-block interleaving rate matching, of the nested PC-polar codes obtained through search. An asterisk mark represents performance, in NR sub-block interleaving rate matching, of NR-constructed polar code (without PC check). A downward-pointing triangular mark represents performance of the NR PC-polar code in NR sub-block interleaving rate matching. Finally, a leftward-pointing triangle mark represents performance, in sub-block interleaving rate matching of the NR PC-polar code, of the PC-polar code having the nesting property provided in this embodiment of this application.

A horizontal axis in the diagram of performance comparison is a code length E after puncturing, with a value ranging from 18 to N (for example, 32). A vertical axis is an SNR required for BLER=0.01. A lower curve indicates better performance.

According to FIG. 8 to FIG. 12, it can be learned that, when the NR sub-block interleaving rate matching manner is used for the PC-polar code having the nesting property provided in this embodiment of this application, performance similar to that of the nested PC-polar codes obtained through search may be obtained, and the performance may be close to performance of the LTE-RM code in FHT decoding.

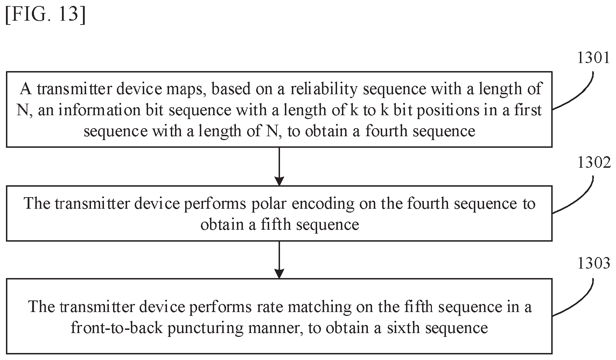

FIG. 13 is a diagram of another polar code encoding method according to an embodiment of this application. As shown in FIG. 13, the method may include the following steps.

Step 1301: A transmitter device maps, based on a reliability sequence with a length of N, an information bit sequence with a length of k to k bit positions in a first sequence with a length of N, to obtain a fourth sequence.

The reliability sequence may be used to indicate reliability corresponding to each bit position in the sequence. A larger value of the reliability indicates higher reliability of a bit position corresponding to the reliability. A length of the reliability sequence may be N, and N is a positive integer.

For example, the reliability sequence may be an NR reliability sequence (or may be described as a reliability sequence corresponding to an NR PC-polar code). For example, the length N of the reliability sequence is 32, and the reliability sequence may be the reliability sequence shown in Table 3.

In another example, the reliability sequence may alternatively be a reliability sequence corresponding to a nested PC-polar code. For example, the length N of the reliability sequence is 32. The reliability sequence may alternatively be a reliability sequence shown in Table 4 below, where $W \left({Q}_{i}^{Nmax}\right)$ represents reliability, and ${Q}_{i}^{Nmax}$ represents a bit position corresponding to reliability.

**Table 4 Reliability sequence**

| $W \left({Q}_{i}^{Nmax}\right)$ | ${Q}_{i}^{Nmax}$ | $W \left({Q}_{i}^{Nmax}\right)$ | ${Q}_{i}^{Nmax}$ | $W \left({Q}_{i}^{Nmax}\right)$ | ${Q}_{i}^{Nmax}$ | $W \left({Q}_{i}^{Nmax}\right)$ | ${Q}_{i}^{Nmax}$ |
|---|---|---|---|---|---|---|---|
| 0 | 0 | 8 | 9 | 16 | 7 | 24 | 13 |
| 1 | 1 | 9 | 6 | 17 | 26 | 25 | 22 |
| 2 | 2 | 10 | 17 | 18 | 19 | 26 | 15 |
| 3 | 4 | 11 | 10 | 19 | 21 | 27 | 23 |
| 4 | 8 | 12 | 18 | 20 | 25 | 28 | 27 |
| 5 | 16 | 13 | 12 | 21 | 28 | 29 | 29 |
| 6 | 3 | 14 | 20 | 22 | 11 | 30 | 30 |
| 7 | 5 | 15 | 24 | 23 | 14 | 31 | 31 |

It may be understood that Table 4 is defined starting from bit 0, or may alternatively be defined starting from bit 1, that is, 0, 1, ..., and 31 may be respectively replaced with 1, 2, ..., and 32. This is not limited.

Refer to the foregoing reliability sequence. The transmitter device may map the information bit sequence with a length of k to the k bit positions in the first sequence with a length of N, to obtain the fourth sequence.

The fourth sequence may include k information bits, 0 PC bits, and (N-k) frozen bits, and both k and N are positive integers.

For example, a value of k may be any one of 3, 4, 5, or 6.

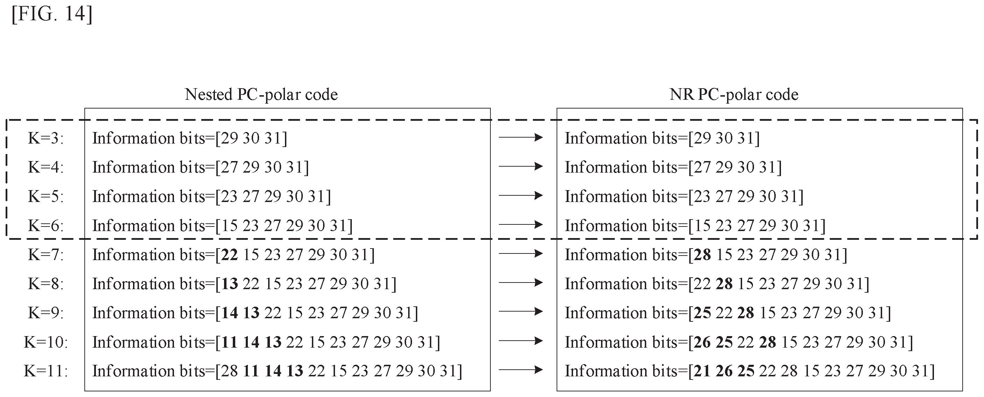

According to the reliability sequence shown in Table 3 or Table 4, as shown in FIG. 14, it can be learned that when a mother code length N of a very short code is 32, and a value of k may be any one of 3, 4, 5, or 6, whether the reliability sequence corresponding to the NR PC-polar code shown in Table 3 or the reliability sequence corresponding to the nested PC-polar code shown in Table 4 is used, finally determined information bits are the same. In addition, rate matching manners corresponding to these k values when a length E after rate matching is equal to {18, 19, 20, 21, ..., 32} are all sub-block interleaving-based rate matching puncturing manners. Therefore, when the value of k may be any one of 3, 4, 5, or 6, the sub-block interleaving-based rate matching manner of the NR PC-polar code may be directly reused.

Based on the foregoing descriptions, the transmitter device may map, based on the reliability sequence with a length of N, the information bit sequence with a length of k to the first k bit positions sorted in descending order of reliability in the first sequence with a length of N, and set remaining (N-k) bit positions to 0, to obtain the fourth sequence.

Optionally, because a quantity of PC bits is 0, a quantity of ${n}_{PC}^{{w}_{min}}$ is also 0, where ${n}_{PC}^{{w}_{min}}$ represents a quantity of PC bits that compromise reliability of information bits and that are in n_{PC} (that is, a quantity of PC bits) PC bits.

For example, N=32 and K=3. When n_{PC}=3 and ${n}_{PC}^{{w}_{min}} = 1$, three most reliable positions 31, 30, and 29 are supposed to be selected as information bits based on the reliability sequence. Because a minimum row weight in an information bit set is 2⁴=16, and ${n}_{PC}^{{w}_{min}} = 1$ means that a position with highest reliability needs to be selected, as a PC bit, from positions whose row weights are 16, the 30^{th} position becomes a PC bit as reliability of 30 is higher given that row weights of both the information bits 30 and 29 are 16. Consequently, 28 becomes a new information bit with reduced reliability.

Step 1302: The transmitter device performs polar encoding on the fourth sequence to obtain a fifth sequence.

The transmitter device may multiply the fourth sequence by a polar encoding matrix, to obtain the fifth sequence.

Step 1303: The transmitter device performs rate matching on the fifth sequence in a front-to-back puncturing manner, to obtain a sixth sequence.

As shown in FIG. 14, information bits when k={3, 4, 5, 6} are respectively (29 30 31), (27 29 30 31), (23 27 29 30 31), and (15 23 27 29 30 31), that is, information bits when k=3 are a subset of information bits when k=4, information bits when k=4 are a subset of information bits when k=5, and information bits when k=5 are a subset of information bits when k=6. Therefore, if a back-to-front shortening (shorten) manner is used in the sub-block interleaving rate matching manner of the NR PC-polar code, these positions are shortened, and a nesting property of the information bit cannot be ensured. In addition, because a code rate of control information is not excessively high, from a perspective of performance, performance is better when the front-to-back puncturing manner is used in a rate matching manner in a medium and low code rate range.

Optionally, before performing rate matching on the fifth sequence in the front-to-back puncturing manner, the transmitter device may further perform sub-block interleaving on the fifth sequence based on a first interleaving pattern.

For example, the first interleaving pattern may be the interleaving pattern shown in Table 1. The first interleaving pattern may also be described as: used to indicate that a value in an A^{th} sub-block of the fifth sequence is to be permuted and placed onto a B^{th} sub-block of the interleaved fifth sequence, and a mapping relationship between A and B is: (31, 31), (30, 30), (29, 29), (27, 28), (28, 27), (26, 26), (25, 25), (24, 24), (23, 23), (15, 22), (22, 21), (14, 20), (21, 19), (13, 18), (20, 17), (12, 16), (19, 15), (11, 14), (18, 13), (10, 12), (17, 11), (9, 10), (16, 9), (8, 8), (7, 7), (6, 6), (5, 5), (3, 4), (4, 3), (2, 2), (1, 1), or (0, 0).

Based on the method shown in FIG. 13, a polar code encoding scheme with a nesting property is provided. For sequences of different quantities k of information bits, k information bits and 0 PC bits may be determined based on the same reliability sequence to construct a polar code. The k information bits and the 0 PC bits have a nesting property for the sequences of different quantities of information bits, and do not change with the quantity of information bits in the sequence. In addition, the PC-polar code having the nesting property obtained based on the k information bits and the 0 PC bits may use the sub-block interleaving rate matching manner, of the NR PC-polar code, featuring front-to-back puncturing, to ensure the nesting property of the information bit. The PC-polar code having the nesting property still has good rate matching performance in the sub-block interleaving rate matching puncturing scheme of the NR PC-polar code. This can simplify a rate matching operation, improve NR compatibility, and improve communication performance.

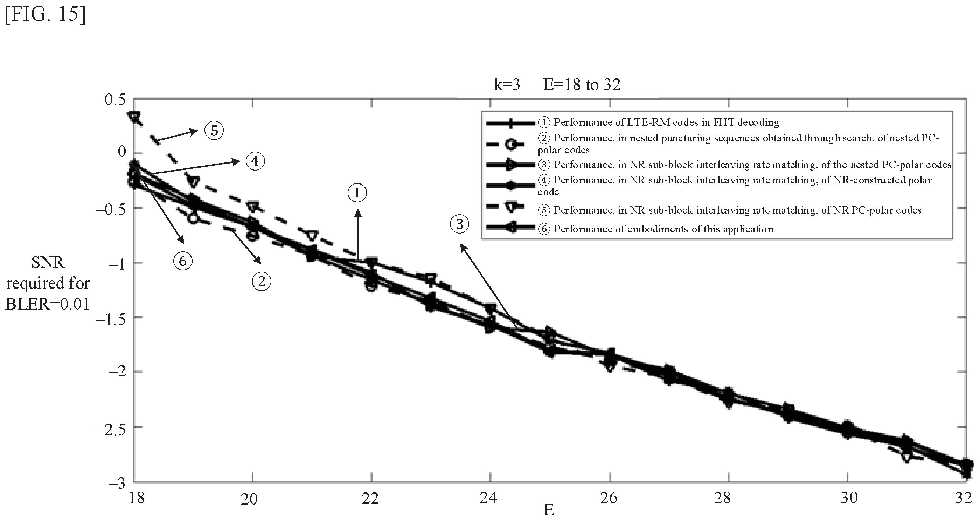

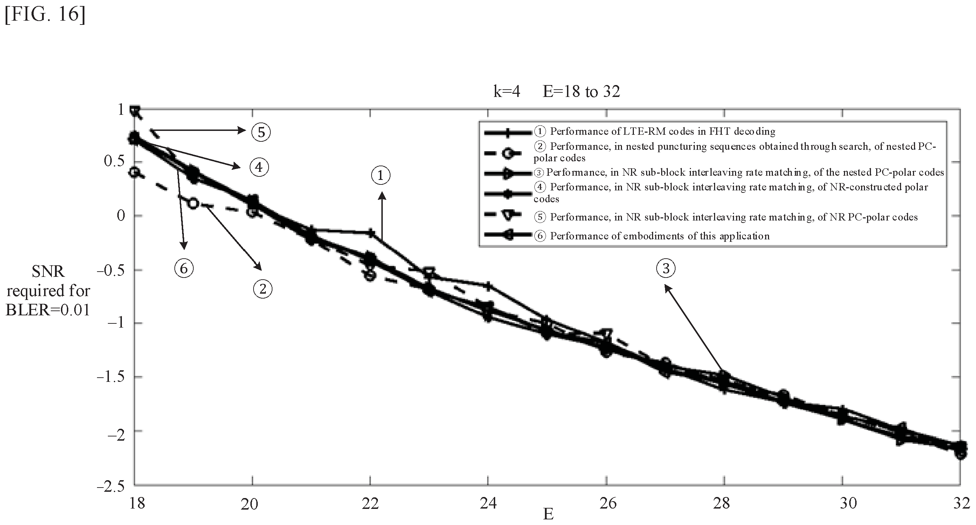

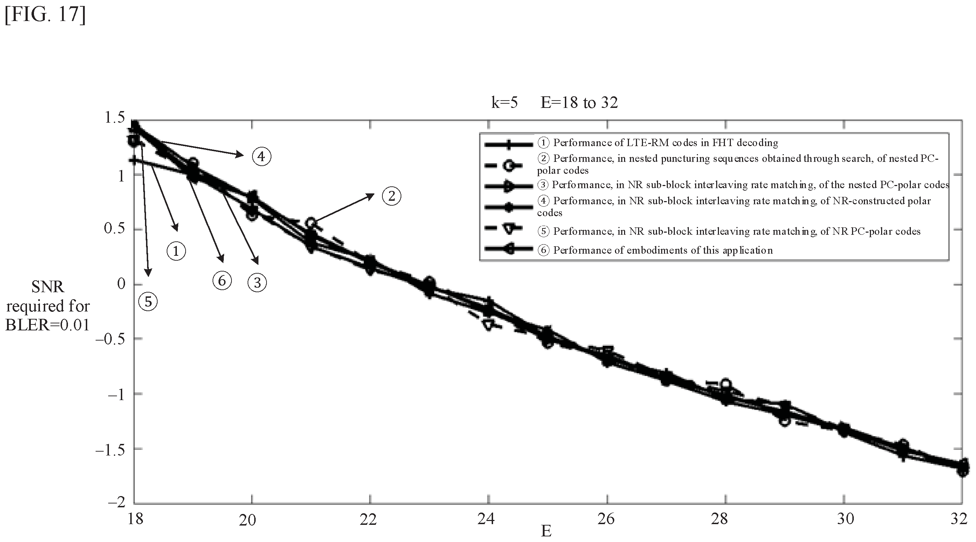

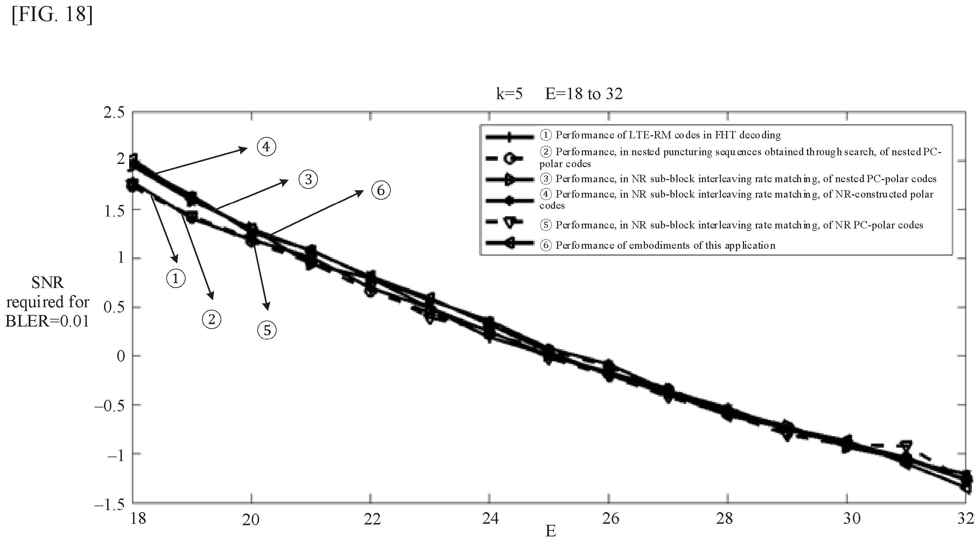

Optionally, based on the method shown in FIG. 13, the following FIG. 15 to FIG. 18 separately provide rate matching performance comparison between different short code schemes (for example, the length of the information bit sequence is 3, 4, 5, or 6). A cross mark represents performance of an LTE-RM code in FHT decoding. A circle mark represents performance, in nested puncturing sequences obtained through search, of nested PC-polar codes obtained through search. A curve of rightward-pointing triangular marks represents performance, in NR sub-block interleaving rate matching, of the nested PC-polar codes obtained through search. An asterisk mark represents performance, in NR sub-block interleaving rate matching, of NR-constructed polar code (without PC check). A downward-pointing triangular mark represents performance of the NR PC-polar code in NR sub-block interleaving rate matching. Finally, a leftward-pointing triangle mark represents performance, in sub-block interleaving rate matching of the NR PC-polar code, of the PC-polar code having the nesting property provided in this embodiment of this application.

A horizontal axis in the diagram of performance comparison is a code length E after puncturing, with a value ranging from 18 to N (for example, 32). A vertical axis is an SNR required for BLER=0.01. A lower curve indicates better performance.

According to FIG. 15 to FIG. 18, it can be learned that, when puncturing of the NR sub-block interleaving rate matching manner is used for the PC-polar code having the nesting property provided in this embodiment of this application, performance similar to that of the nested PC-polar codes obtained through search may be obtained, and the performance may be close to performance of the LTE-RM code in FHT decoding.

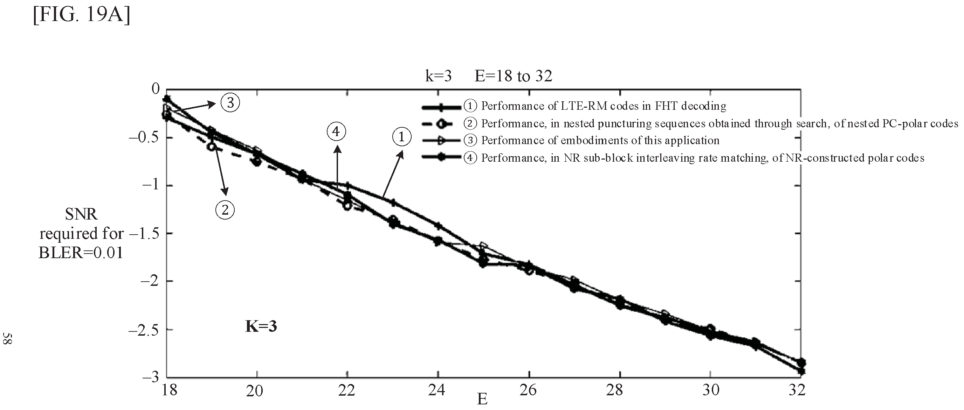

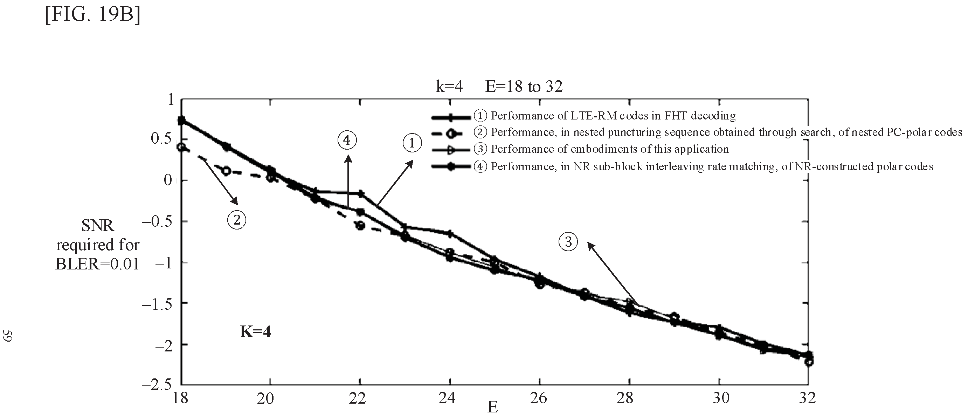

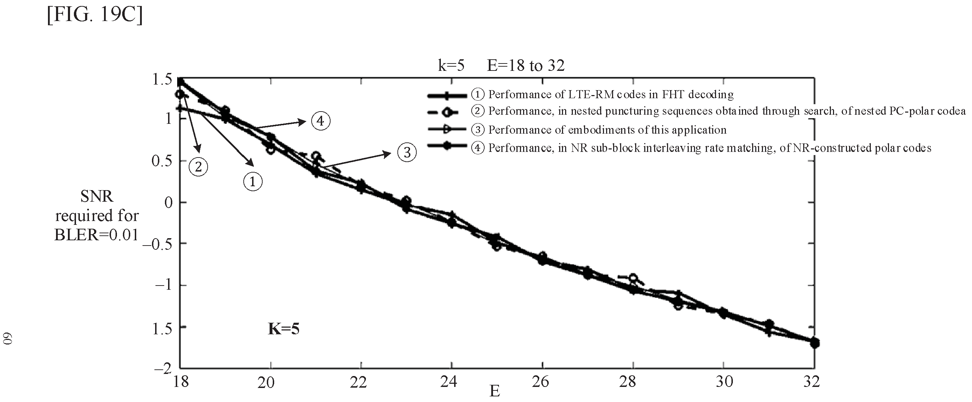

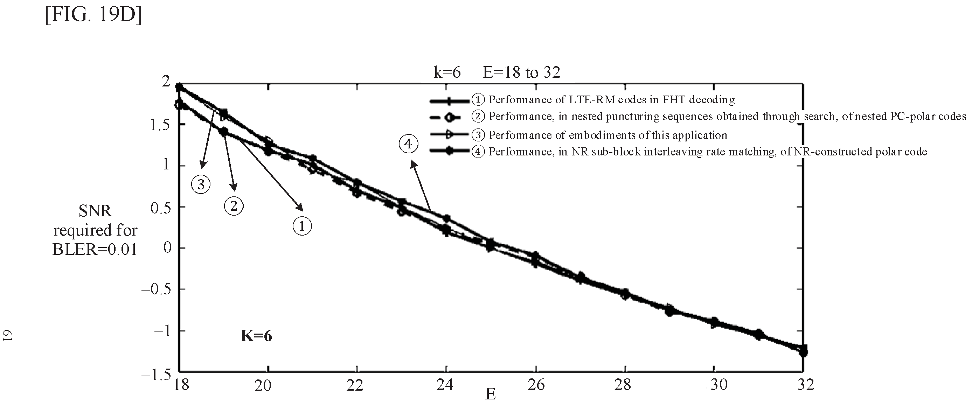

Optionally, based on the method shown in FIG. 13, the following FIG. 19A to FIG. 19D provides rate matching performance comparison between different short code schemes (for example, the length of the information bit sequence is 3, 4, 5, or 6). A cross mark represents performance of an LTE-RM code in FHT decoding. A circle mark represents performance, in nested puncturing sequences obtained through search, of nested PC-polar codes obtained through search. An asterisk mark represents performance, in NR sub-block interleaving rate matching, of NR-constructed polar code (without PC check). A triangle mark corresponds to performance, in puncturing of the NR sub-block interleaving rate matching manner, of the PC-polar code having the nesting property provided in this embodiment of this application.

A horizontal axis in the diagram of performance comparison is a code length E after puncturing, with a value ranging from 18 to N (for example, 32). A vertical axis is an SNR required for BLER=0.01. A lower curve indicates better performance.

According to FIG. 19A to FIG. 19D, it can be learned that, performance, in puncturing of the NR sub-block interleaving rate matching manner, of the PC-polar code having the nesting property provided in this embodiment of this application, is close to performance of a previous performance-based puncturing sequence obtained through a nested search, and is better than performance of an LTE-RM code in rate matching.

It should be noted that, in the foregoing embodiments, that definition is provided starting from bit 0 is used as an example for description. It may be understood that the definition may alternatively be provided starting from bit 1 for description, that is, 0, 1, ..., and 31 may be respectively replaced with 1, 2, ..., and 32. This is not limited.

In addition, in the foregoing methods, very short codes (very short codes) with the length of the information bit sequence being 3 to 11 are used as an example for description. It may be understood that the very short code is not limited to the length of 3 to 11, and may have another length. The information bit sequence may alternatively be a pre-transformed polar (pre-transformed polar) code, a polarization-adjusted convolutional (polarization-adjusted convolutional, PAC) code, or the like. This is not limited.

It should be noted that various embodiments of this application may be implemented separately, or may be implemented in combination. This is not limited. Unless otherwise stated or there is a logic conflict, terms and/or descriptions in different embodiments provided by this application are consistent and may be mutually referenced, and technical features in different embodiments may be combined based on an internal logical relationship thereof, to form a new embodiment.

It may be understood that, in embodiments of this application, an execution body may perform some or all of the steps in embodiments of this application. The steps or operations are merely examples. Embodiments of this application may further include performing other operations or variations of various operations. In addition, the steps may be performed in a sequence different from that shown in embodiments of this application, and possibly, not all the operations in embodiments of this application need to be performed.

The solutions provided in embodiments of this application are mainly described above from a perspective of interaction between the devices. It may be understood that, to implement the foregoing functions, each device includes a corresponding hardware structure and/or a corresponding software module for performing each function. A person of ordinary skill in the art should easily be aware that, in combination with algorithms and steps in the examples described in embodiments disclosed in this specification, this application can be implemented by hardware or a combination of hardware and computer software. Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

In embodiments of this application, the devices may be divided into functional modules based on the foregoing method examples. For example, each functional module may be obtained through division for each corresponding function, or two or more than two functions may be integrated into one processing module. The integrated module may be implemented in a form of hardware, or may be implemented in a form of a software functional module. It should be noted that, in embodiments of this application, division into the modules is an example and is merely logical function division, and there may be other division in an actual implementation.

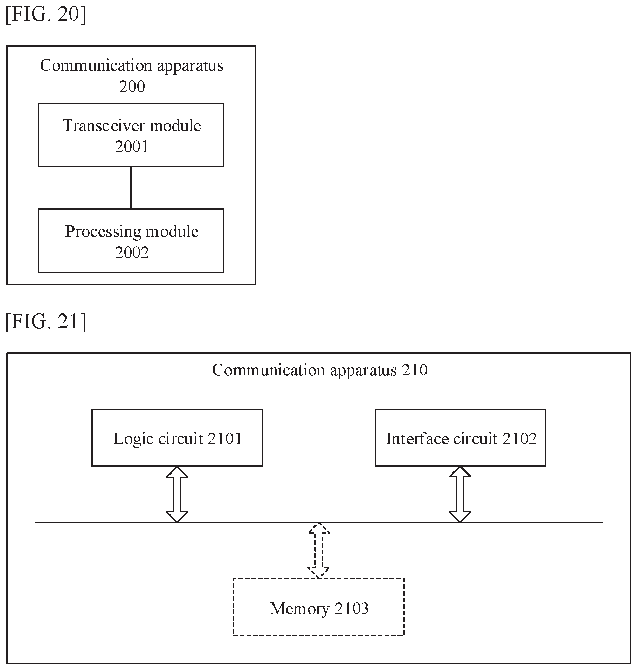

When each functional module is obtained through division for each corresponding function, FIG. 20 shows a communication apparatus 200. The communication apparatus 200 may perform actions performed by the transmitter device in the methods shown in FIG. 5 to FIG. 19D. All related content of steps in the foregoing method embodiments may be referenced in functional descriptions of corresponding functional modules. For technical effects that can be achieved by the communication apparatus 200, refer to the foregoing method embodiments. Details are not described herein again.

The communication apparatus 200 may include a transceiver module 2001 and a processing module 2002. For example, the communication apparatus 200 may be a communication device, or may be a chip used in the communication device, or another combined device or component that has a function of the communication apparatus. When the communication apparatus 200 is a communication device, the transceiver module 2001 may be a transceiver, where the transceiver may include an antenna, a radio frequency circuit, and the like; and the processing module 2002 may be a processor (or a processing circuit), for example, a baseband processor, where the baseband processor may include one or more CPUs. When the communication apparatus 200 is a component that has a function of the communication apparatus, the transceiver module 2001 may be a radio frequency unit, and the processing module 2002 may be a processor (or a processing circuit), for example, a baseband processor. When the communication apparatus 200 is a chip system, the transceiver module 2001 may be an input/output interface of a chip (for example, a baseband chip); and the processing module 2002 may be a processor (or a processing circuit) of the chip system, and may include one or more central processing units. It should be understood that the transceiver module 2001 in this embodiment of this application may be implemented by a transceiver or a transceiver-related circuit component, and the processing module 2002 may be implemented by a processor or a processor-related circuit component (or referred to as a processing circuit).

For example, the transceiver module 2001 may be configured to perform all receiving and sending operations performed by the communication apparatus in embodiments shown in FIG. 5 to FIG. 19D, and/or configured to support another process of the technology described in this specification. The processing module 2002 may be configured to perform all operations other than the receiving and sending operations performed by the communication apparatus in embodiments shown in FIG. 5 to FIG. 19D, and/or configured to support another process of the technology described in this specification.

In another possible implementation, the transceiver module 2001 in FIG. 20 may be replaced with a transceiver, and a function of the transceiver module 2001 may be integrated into the transceiver. The processing module 2002 may be replaced with a processor, and a function of the processing module 2002 may be integrated into the processor. Further, the communication apparatus 200 shown in FIG. 20 may further include a memory.

Alternatively, when the processing module 2002 is replaced with a processor, and the transceiver module 2001 is replaced with a transceiver, the communication apparatus 200 in this embodiment of this application may be a communication apparatus 210 shown in FIG. 21. The processor may be a logic circuit 2101, and the transceiver may be an interface circuit 2102. Further, the communication apparatus 210 shown in FIG. 21 may further include a memory 2103.

An embodiment of this application further provides a computer program product. When the computer program product is executed by a computer, functions in any one of the foregoing method embodiments may be implemented.

An embodiment of this application further provides a computer program. When the computer program is executed by a computer, functions in any one of the foregoing method embodiments may be implemented.

An embodiment of this application further provides a computer-readable storage medium. All or some of procedures in the foregoing method embodiments may be implemented by a computer program instructing related hardware. The program may be stored in the foregoing computer-readable storage medium. When the program is executed, the procedures in the foregoing method embodiments may be included. The computer-readable storage medium may be an internal storage unit in the terminal (including a data transmit end and/or a data receive end) in any one of the foregoing embodiments, for example, a hard disk or memory of the terminal. The foregoing computer-readable storage medium may alternatively be an external storage device of the foregoing terminal, for example, a plug-in hard disk, a smart media card (smart media card, SMC), a secure digital (secure digital, SD) card, or a flash card (flash card) that is configured on the terminal. Further, the computer-readable storage medium may alternatively include both an internal storage unit and an external storage device of the terminal. The computer-readable storage medium is configured to store the computer program and other programs and data required by the terminal. The computer-readable storage medium may be further configured to temporarily store data that has been output or is to be output.

It should be noted that, in the specification, claims, and accompanying drawings of this application, the terms "first", "second", and the like are intended to distinguish between different objects but do not indicate a particular order. "First" and "second" are merely intended for a purpose of description, and shall not be understood as an indication or implication of relative importance or implicit indication of a quantity of indicated technical features. Therefore, a feature limited by "first" or "second" may explicitly or implicitly include one or more features. In the description of embodiments, unless otherwise specified, "plurality" means two or more.

In addition, the terms "including" and "having" and any other variants thereof are intended to cover a non-exclusive inclusion. For example, a process, a method, a system, a product, or a device that includes a series of steps or units is not limited to the listed steps or units, but optionally further includes an unlisted step or unit, or optionally further includes another step or unit inherent to the process, the method, the product, or the device.

It should be understood that in this application, "at least one (item)" means one or more. ''Plurality'' means two or more than two, "At least two (items)" means two, three, or more than three. "And/or" is used to describe an association relationship between associated objects, and indicates that three relationships may exist. For example, "A and/or B" may represent three cases: Only A exists, only B exists, and both A and B exist, where A and B may be singular or plural. The character "/" generally indicates an "or" relationship between the associated objects. "At least one of the following items (pieces)" or a similar expression thereof means any combination of these items, including any combination of singular items (pieces) or plural items (pieces). For example, at least one of a, b, or c may indicate a, b, c, a and b, a and c, b and c, or a, b, and c, where a, b, and c may be singular or plural. Both "when ..." and "if" mean that corresponding processing is performed in an objective case, and are not intended to limit time. The terms do not require a determining action during implementation, and do not mean that there is another limitation.

In embodiments of this application, the word such as "example" or "for example" is used to represent an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

In this application, "sending information to ... (a terminal device)" may be understood as that a destination end of the information is the terminal device, and may include directly or indirectly sending the information to the terminal device; and "receiving information from ... (a terminal device)" may be understood as that a source end of the information is the terminal device, and may include directly or indirectly receiving the information from the terminal device. The information may undergo necessary processing, for example, a format change, between the source end for sending the information and the destination end. However, the destination end may understand valid information from the source end.

Based on the descriptions of the implementations, a person skilled in the art may clearly understand that for the purpose of convenient and brief descriptions, division into the foregoing functional modules is merely used as an example for descriptions. During actual application, the functions may be allocated to different functional modules for implementation based on a requirement. In other words, an inner structure of an apparatus is divided into different functional modules to implement all or some of the functions described above.

In the several embodiments provided in this application, it should be understood that the disclosed apparatus and method may be implemented in other manners. For example, the foregoing apparatus embodiment is merely an example. For example, division into the modules or the units is merely logical function division and may be other division in actual implementation. For example, a plurality of units or components may be combined or integrated into another apparatus, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may be one or more physical units, that is, the parts may be located in one place or distributed in different places. Some or all of the units may be selected based on actual requirements to achieve the objectives of the solutions of embodiments.

In addition, functional units in embodiments of this application may be integrated into one processing unit, or each of the units may exist alone physically, or two or more units may be integrated into one unit. The integrated unit may be implemented in a form of hardware, or may be implemented in a form of a software functional unit.

When the integrated unit is implemented in the form of a software functional unit and sold or used as an independent product, the integrated unit may be stored in a readable storage medium. Based on such understanding, the technical solutions of embodiments of this application essentially or all or some of the technical solutions may be implemented in the form of a software product. The software product is stored in a storage medium and includes several instructions for instructing a device (which may be a single-chip microcomputer, a chip or the like) or a processor (processor) to perform all or some of the steps of the methods described in embodiments of this application. The foregoing storage medium includes any medium that can store program code, such as a USB flash drive, a removable hard disk, a ROM, a RAM, a magnetic disk, or an optical disc.

## Claims

1. A polar code encoding method, comprising:
mapping, based on a reliability sequence with a length of N, an information bit sequence with a length of k to k bit positions in a first sequence with a length of N, to obtain a second sequence, wherein the second sequence comprises k information bits, x parity check PC bits, and (N-k-x) frozen bits, and k, N, and
x are all positive integers; m information bits in the k information bits are at first m bit positions in the second sequence sorted in descending order of reliability,
and remaining (k-m) information bits in the k information bits are at bit positions that are in the second sequence and that correspond to first (k-m) information bits in a preset information bit set sorted in descending order of reliability; and the x PC bits are x PC bits in a preset PC bit set; and
performing polar encoding on the second sequence to obtain a third sequence.

2. The method according to claim 1, wherein
a value of k is any one of 7, 8, 9, 10, or 11.

3. The method according to claim 1 or 2, wherein
the m information bits are at the following bit positions in the second sequence: 15, 23, 27, 29, 30, and 31.

4. The method according to any one of claims 1 to 3, wherein
the preset information bit set corresponds to the following bit positions in the second sequence: 11, 19, 13, 14, and 22.

5. The method according to any one of claims 1 to 4, wherein
a difference between indexes of any two bit positions checked by the PC bit is not 1.

6. The method according to any one of claims 1 to 5, wherein
the preset PC bit set corresponds to the following bit positions in the second sequence: 21, 26, 25, and 28.

7. The method according to claim 6, wherein
when the PC bit is at the 21^{st} bit position in the second sequence, a bit position checked by the PC bit is one or more of the following bit positions in the second sequence: 11 and 14; or
when the PC bit is at the 26^{th} bit position in the second sequence, a bit position checked by the PC bit is one or more of the following bit positions in the second sequence: 13 and 19; or
when the PC bit is at the 25^{th} bit position in the second sequence, a bit position checked by the PC bit is one or more of the following bit positions in the second sequence: 13 and 22; or
when the PC bit is at the 28^{th} bit position in the second sequence, a bit position checked by the PC bit is one or more of the following bit positions in the second sequence: 11, 13, and 19.

8. The method according to any one of claims 1 to 7, wherein
a bit position 7 in the second sequence is a frozen bit.

9. A polar code encoding method, comprising:
mapping, based on a reliability sequence with a length of N, an information bit sequence with a length of k to k bit positions in a first sequence with a length of N, to obtain a fourth sequence, wherein the fourth sequence comprises k information bits, 0 parity check PC bits, and (N-k) frozen bits, and both k and N are positive integers;
performing polar encoding on the fourth sequence to obtain a fifth sequence; and
performing rate matching on the fifth sequence in a front-to-back puncturing manner, to obtain a sixth sequence.

10. The method according to claim 9, wherein
a value of k is any one of 3, 4, 5, or 6.

11. The method according to claim 9 or 10, wherein before performing rate matching on the fifth sequence in the front-to-back puncturing manner, the method further comprises:
performing sub-block interleaving on the fifth sequence based on a first interleaving pattern, wherein
the first interleaving pattern is used to indicate that a value in an A^{th} sub-block of the fifth sequence is to be permuted and placed onto a B^{th} sub-block of the interleaved fifth sequence, and a mapping relationship between A and B is: (31, 31), (30, 30), (29, 29), (27, 28), (28, 27), (26, 26), (25, 25), (24, 24), (23, 23), (15, 22), (22, 21), (14, 20), (21, 19), (13, 18), (20, 17), (12, 16), (19, 15), (11, 14), (18, 13), (10, 12), (17, 11), (9, 10), (16, 9), (8, 8), (7, 7), (6, 6), (5, 5), (3, 4), (4, 3), (2, 2), (1, 1), or (0, 0).

12. A communication apparatus, comprising:
a processing module, configured to map, based on a reliability sequence with a length of N, an information bit sequence with a length of k to k bit positions in a first sequence with a length of N, to obtain a second sequence, wherein the second sequence comprises k information bits, x parity check PC bits, and (N-k-x) frozen bits, and k, N, and x are all positive integers; m information bits in the k information bits are at first m bit positions in the second sequence sorted in descending order of reliability, and remaining (k-m) information bits in the k information bits are at bit positions that are in the second sequence and that correspond to first (k-m) information bits in a preset information bit set sorted in descending order of reliability; and the x PC bits are x PC bits in a preset PC bit set, wherein
the processing module is further configured to perform polar encoding on the second sequence to obtain a third sequence.

13. The apparatus according to claim 12, wherein
a value of k is any one of 7, 8, 9, 10, or 11.

14. The apparatus according to claim 12 or 13, wherein
the m information bits are at the following bit positions in the second sequence: 15, 23, 27, 29, 30, and 31.

15. The apparatus according to any one of claims 12 to 14, wherein
the preset information bit set corresponds to the following bit positions in the second sequence: 11, 19, 13, 14, and 22.

16. The apparatus according to any one of claims 12 to 15, wherein
a difference between indexes of any two bit positions checked by the PC bit is not 1.

17. The apparatus according to any one of claims 12 to 16, wherein
the preset PC bit set corresponds to the following bit positions in the second sequence: 21, 26, 25, and 28.

18. The apparatus according to claim 17, wherein
when the PC bit is at the 21^{st} bit position in the second sequence, a bit position checked by the PC bit is one or more of the following bit positions in the second sequence: 11 and 14; or
when the PC bit is at the 26^{th} bit position in the second sequence, a bit position checked by the PC bit is one or more of the following bit positions in the second sequence: 13 and 19; or
when the PC bit is at the 25^{th} bit position in the second sequence, a bit position checked by the PC bit is one or more of the following bit positions in the second sequence: 13 and 22; or
when the PC bit is at the 28^{th} bit position in the second sequence, a bit position checked by the PC bit is one or more of the following bit positions in the second sequence: 11, 13, and 19.

19. The apparatus according to any one of claims 12 to 18, wherein
a bit position 7 in the second sequence is a frozen bit.

20. A communication apparatus, comprising:
a processing module, configured to map, based on a reliability sequence with a length of N, an information bit sequence with a length of k to k bit positions in a first sequence with a length of N, to obtain a fourth sequence, wherein the fourth sequence comprises k information bits, 0 parity check PC bits, and (N-k) frozen bits, and both k and N are positive integers, wherein
the processing module is further configured to perform polar encoding on the fourth sequence to obtain a fifth sequence; and
the processing module is further configured to perform rate matching on the fifth sequence in a front-to-back puncturing manner, to obtain a sixth sequence.

21. The apparatus according to claim 20, wherein
a value of k is any one of 3, 4, 5, or 6.

22. The apparatus according to claim 20 or 21, wherein before performing rate
matching on the fifth sequence in the front-to-back puncturing manner, the processing module is further configured to:
perform sub-block interleaving on the fifth sequence based on a first interleaving pattern, wherein
the first interleaving pattern is used to indicate that a value in an A^{th} sub-block of the fifth sequence is to be permuted and placed onto a B^{th} sub-block of the interleaved fifth sequence, and a mapping relationship between A and B is: (31, 31), (30, 30), (29, 29), (27, 28), (28, 27), (26, 26), (25, 25), (24, 24), (23, 23), (15, 22), (22, 21), (14, 20), (21, 19), (13, 18), (20, 17), (12, 16), (19, 15), (11, 14), (18, 13), (10, 12), (17, 11), (9, 10), (16, 9), (8, 8), (7, 7), (6, 6), (5, 5), (3, 4), (4, 3), (2, 2), (1, 1), or (0, 0).

23. A communication apparatus, wherein the communication apparatus comprises a processor, and the processor is configured to run a computer program or instructions, so that the polar code encoding method according to any one of claims 1 to 8 is performed, or the polar code encoding method according to any one of claims 9 to 11 is performed.

24. The communication apparatus according to claim 23, wherein
the communication apparatus further comprises a memory, and the memory is configured to store the computer program or the instructions.

25. A communication apparatus, wherein the communication apparatus comprises an interface circuit and a logic circuit, the interface circuit is configured to input and/or output information, and the logic circuit is configured to perform the polar code encoding method according to any one of claims 1 to 8 or the polar code encoding method according to any one of claims 9 to 11, and perform processing based on the information and/or generate information based on the information.

26. A computer-readable storage medium, wherein the computer-readable storage medium stores computer instructions or a program, and when the computer instructions or the program is run on a computer, the polar code encoding method according to any one of claims 1 to 8 is performed, or the polar code encoding method according to any one of claims 9 to 11 is performed.

27. A computer program product, wherein the computer program product comprises computer instructions, and when some or all of the computer instructions are run on a computer, the polar code encoding method according to any one of claims 1 to 8 is performed, or the polar code encoding method according to any one of claims 9 to 11 is performed.
